# EUROPEAN PATENT APPLICATION

(11) **EP 2 065 915 A1**
(43) Date of publication of application: **03.06.2009**
(21) Application number: 07807459.8
(22) Date of filing: 18.09.2007
(51) Int. Cl.: H01J 9/02, H01J 1/304

(54) **DIAMOND ELECTRON SOURCE AND METHOD FOR MANUFACTURING THE SAME**

(30) Priority: 19.09.2006 JP 2006252191; 30.01.2007 JP 2007018803; 12.09.2007 JP 2007236851
(71) Applicant: Sumitomo Electric Industries, Ltd., Osaka-shi, Osaka 541-0041 (JP)
(72) Inventor: UEDA, Akihiko, Hyogo 664-0016 (JP); YAMAMOTO, Yoshiyuki, Hyogo 664-0016 (JP); NISHIBAYASHI, Yoshiki, Hyogo 664-0016 (JP); IMAI, Takahiro, Hyogo 664-0016 (JP)
(74) Representative: Cross, Rupert Edward Blount
(86) International application number: PCT/JP2007/068058
(87) International publication number: WO 2008/035662

(57) **Abstract**

A diamond electron source in which a single sharpened tip is formed at one end of a pillar-shaped diamond monocrystal of a size for which resist application is difficult in a microfabrication process, as an electron emission point used in an electron microscope or other electron beam device, and a method for manufacturing the diamond electron source.

One end of a pillar-shaped diamond monocrystal 10 is ground to form a smooth flat surface 11, and a ceramic layer 12 is formed on the smooth flat surface 11. A thin-film layer 14 having a prescribed shape is deposited on the ceramic layer 12 using a focused ion beam device, after which the ceramic layer 12 is patterned by etching using the thin-film layer 14 as a mask. A single sharpened tip is formed at one end of the pillar-shaped diamond monocrystal 10 by dry etching using the resultant ceramic mask.

## Description

### Technical Field

The present invention relates to a diamond electron source having high brightness in which only one sharpened tip is formed at one end of a pillar-shaped diamond monocrystal of a size for which resist application is difficult in a microfabrication process, as an electron emission point used in an electron microscope, electron beam exposure device, or other electron beam device, and to a method for manufacturing the diamond electron source.

### Background Art

Diamond exists in a state of negative electron affinity (NEA), or a state of small positive electron affinity (PEA), and is therefore considered to be a good electron emitting material. Numerous proposals have been made that relate to electron emission elements or manufacturing methods thereof that use diamond and utilize the properties of diamond.

However, in order to use diamond as an electron emission element, the electron emission point must be controlled, but diamond has drawbacks in being extremely difficult to process. Therefore, numerous micro-processing methods that use dry etching have been proposed as methods for forming a sharpened tip as an electron emission point in a diamond in particular.

For example, methods for forming a sharpened tip in a diamond by dry etching are described in Japanese Laid-open Patent Application Nos. 2002-075171 and 2005-353449. However, since a mask processed in a lithography step using light or an electron beam is used in these methods, it is necessary to use a diamond substrate that has an adequately large surface area to allow uniform application of the resist.

Consequently, the abovementioned methods are effective as methods for forming a plurality of arranged sharpened tips that can be applied to a planar electron source such as a FED (Field Emission Display) or the like, for example. However, when a diamond electron source is mounted in an electron microscope, electron beam exposure device, or other electron-beam device, since the electron source used in these devices is commonly an LaB₆, ZrO/W, or other point electron source, the shape of the diamond electron source should preferably remain a pillar shape having only one sharp end point in the same manner as in the prior art to provide interchangeability with the conventional electron source.

When the aforementioned publicly known techniques are used as to manufacture a diamond electron source that has a single sharpened tip, a method may be used in which a mask is formed on the surface of one end of a pillar-shaped diamond by a lithography step, and the end is sharpened by dry etching. However, from the perspective of the crystal size of the LaB₆ used in the point electron source, the resist is extremely difficult to uniformly apply to one end surface of a pillar-shaped diamond of this size by spin coating or spray coating, and the lithography step is not easy to use.

It may also be possible to use a method in which a plurality of sharpened tips is formed by a lithography step on a surface that is large enough to allow resist application, and a pillar-shaped diamond having only one sharpened tip is cut off by a laser or other method that enables diamond cutting. However, when cutting is performed after the sharpened tips are formed, drawbacks occur in that the sharpened tips are damaged during working.

A method may also be used for sharpening one end of a pillar-shaped diamond monocrystal by polishing. However, although end sharpening for creating a rotationally symmetrical shape whereby an electron beam can be focused in a minute region is possible by dry etching, since a diamond varies in hardness according to the plane direction in polishing, a sharpened tip having a rotationally asymmetrical shape such as an elliptical cone, for example, is likely to form, which is unsuitable for application in an electron beam device.

Patent Document 1: Japanese Laid-open Patent Application No. 2002-075171
Patent Document 2: Japanese Laid-open Patent Application No. 2005-353449

### DISCLOSURE OF THE INVENTION

### Problems to Be Solved by the Invention

The present invention was developed in view of the drawbacks of the prior art, and an object of the present invention is to provide a method for forming a single sharpened tip at one end of a pillar-shaped diamond monocrystal of a size for which resist application is difficult in a microfabrication process in a diamond electron source having only one sharpened tip as an electron emission point used in an electron microscope, electron beam exposure device, or other electron beam device, and to provide a high-brightness diamond electron source in which a single sharpened tip is formed at one end of a pillar-shaped diamond monocrystal of a size for which resist application is difficult.

### Means Used to Solve the Above-Mentioned Problems

In order to overcome the abovementioned problems, the method for manufacturing a diamond electron source having a single sharpened tip as an electron emission point of a diamond according to the present invention is characterized in comprising a step A of preparing a pillar-shaped diamond monocrystal of a size for which resist application is difficult in a microfabrication process; a step B of polishing at least one end of the pillar-shaped diamond monocrystal and forming a smooth flat surface; a step C of forming a ceramic layer on the smooth flat surface; a step D of depositing and forming a thin-film layer having a prescribed shape on at least a portion of the ceramic layer using a focused ion beam device; a step E of patterning the ceramic layer by wet etching or dry etching using the thin-film layer as a mask, and fabricating a ceramic mask; and a step F of using the ceramic mask to form a single sharpened tip at one end of the pillar-shaped diamond monocrystal by dry etching.

In the method of the present invention described above, a patterned ceramic-layer mask is used to form a single sharpened tip at one end of the pillar-shaped diamond monocrystal, but a thin-film layer having the desired shape is formed on the ceramic layer using a function of a focused ion beam device (FIB) for depositing a thin-film layer in an arbitrary shape in order to form the ceramic mask by wet etching or dry etching. Through the use of an FIB, since a thin-film layer in the desired shape can be formed even on a flat surface of a size for which resist application is difficult, the microfabrication process of the sharpened tip can be applied without a photolithography step. In this case, the shape of the thin-film layer formed by the FIB is preferably circular in order to ultimately fabricate a rotationally symmetrical sharpened tip.

The method for manufacturing a diamond electron source according to a second aspect of the present invention is characterized in comprising a step A of preparing a pillar-shaped diamond monocrystal of a size for which resist application is difficult in a microfabrication process; a step B of polishing at least one end of the pillar-shaped diamond monocrystal and forming a smooth flat surface; a step C of forming a ceramic layer on the smooth flat surface; a step G of forming an iron-based metal or Cr (chrome) layer on the ceramic layer; a step H of depositing and forming a thin-film layer having a prescribed shape on at least a portion of the iron-based metal or Cr layer using a focused ion beam device; a step I of patterning the iron-based metal or Cr layer by wet etching or dry etching using the thin-film layer as a mask, and fabricating an iron-based metal or Cr mask; a step J of using the iron-based metal or Cr mask to pattern the ceramic layer by wet etching or dry etching, and fabricating a ceramic mask; and a step K of using the patterned ceramic mask to form a single sharpened tip at one end of the pillar-shaped diamond monocrystal by dry etching.

Since a thick ceramic layer becomes necessary according to the shape of the sharpened tip to be formed in the pillar-shaped diamond monocrystal, it is sometimes necessary to pattern a thick ceramic layer by etching using a metal layer as a mask. However, when the selectivity of the metal layer and the ceramic layer is small, the metal layer sometimes disappears first, and the ceramic layer cannot be patterned in the desired shape. Therefore, in the second method, the iron-based metal or Cr layer is patterned using a metal layer as a mask, and the resultant iron-based metal or Cr mask is used to pattern the ceramic layer. An iron-based metal or Cr layer often has high selectivity with respect to the ceramic layer. According to this method, a diamond electron source having the desired sharpened tip can be fabricated even when the ceramic layer is thick.

The method for manufacturing a diamond electron source according to a third aspect of the present invention is characterized in comprising the step A and step B described above, as well as a step L of forming an iron-based metal or Cr layer on the smooth flat surface; a step M of depositing and forming a thin-film layer having a prescribed shape on at least a portion of the iron-based metal or Cr layer using a focused ion beam device; a step N of patterning the iron-based metal or Cr layer by wet etching or dry etching using the thin-film layer as a mask, and fabricating an iron-based metal or Cr mask; and a step O of using the iron-based metal or Cr mask to form a single sharpened tip at one end of the pillar-shaped diamond monocrystal by dry etching.

In the method of the present invention described above, a patterned iron-based metal or Cr layer is used as a mask to form a single sharpened tip at one end of a pillar-shaped diamond monocrystal, but because the iron-based metal or Cr mask is formed by wet or dry etching, a thin-film layer having the desired shape is formed on the iron-based metal or Cr layer using a function of a focused ion beam device (FIB) for depositing a thin-film layer having an arbitrary shape. Through the use of an FIB, since a thin-film layer in the desired shape can be formed even on a flat surface of a size for which resist application is difficult, the microfabrication process of the sharpened tip can be applied without a photolithography step. When an iron-based metal or Cr is used instead of the aforementioned ceramic in this manner, the selectivity with respect to diamond increases during dry etching, and the thickness of the iron-based metal or Cr layer may therefore be relatively small, and the adhesion to the diamond is good. The potential for separation of the mask during the process is therefore reduced, and process yield is enhanced. In this case, the shape of the thin-film layer formed by the FIB is preferably circular in order to ultimately fabricate a rotationally symmetrical sharpened tip.

The method for manufacturing a diamond electron source according to a fourth aspect of the present invention is characterized in comprising the step A and step B described above, as well as a step P of depositing and forming an SiOₓ layer having a prescribed shape on at least a portion of the smooth flat surface using a focused ion beam device, and a step Q of forming a single sharpened tip at one end of the pillar-shaped diamond monocrystal by dry etching using the SiOₓ layer as a mask. This method is preferably used when an SiOₓ layer having an arbitrary shape can be deposited using an FIB. Through the use of this method, the number of steps can be reduced in relation to the previously described first through third methods for manufacturing a diamond electron source, and the process yield can be significantly enhanced as a result.

The method for manufacturing a diamond electron source according to a fifth aspect of the present invention is characterized in comprising the step A and step B described above, as well as a step R of depositing and forming a Ni (nickel) layer having a prescribed shape on at least a portion of the smooth flat surface using a focused ion beam device, and a step S of forming a single sharpened tip at one end of the pillar-shaped diamond monocrystal by dry etching using the Ni layer as a mask. This method is preferably used when an Ni layer having an arbitrary shape can be deposited using an FIB. Through the use of this method, the number of steps can be reduced in relation to the previously described first through third methods for manufacturing a diamond electron source, and the process yield can be significantly enhanced as a result. Furthermore, in comparison to the case of the method for manufacturing a diamond electron source according to the fourth aspect in which a SiOₓ layer is used as the mask, since the selectivity with respect to diamond increases when an Ni layer is used as the mask, the thickness of the Ni layer may be relatively small, and the adhesion to the diamond is good. The potential for separation of the mask during the process is therefore reduced, and process yield is enhanced.

The abovementioned method for manufacturing a diamond electron source according to the present invention may further comprise a step T of grinding and sharpening a side surface of one end so that a smooth flat surface is formed at an apex part immediately before or immediately after the step B of polishing one end and forming a smooth flat surface. The step T is provided, whereby the electric field concentration on the sharpened tip is increased when electrons are emitted by an electric field from the completed diamond electron source. As a result, a diamond electron source having higher brightness is obtained.

The abovementioned method for manufacturing a diamond electron source according to the present invention may further comprise a step U of forming an adhesion strengthening layer between the smooth flat surface and the ceramic layer as a step between the step B and the step C. The adhesion between the smooth diamond flat surface and the ceramic layer is significantly enhanced by the adhesion strengthening layer, and as a result, the process yield is markedly enhanced. A Ti (titanium) layer, for example, may be suitably used as the adhesion strengthening layer.

A step U of forming an adhesion strengthening layer between the smooth flat surface and the SiOₓ layer may also be provided as a step between the step B and the step P. The adhesion between the smooth diamond flat surface and the SiOₓ layer is thereby significantly enhanced, and as a result, the process yield is markedly enhanced. A Ti layer, for example, may be suitably used as the adhesion strengthening layer.

A step U of forming an adhesion strengthening layer between the ceramic layer and the thin-film layer may also be provided as a step between the step C and the step D. The adhesion between the ceramic layer and the thin-film layer is thereby significantly enhanced, and as a result, the process yield is markedly enhanced. A Ti layer, for example, may be suitably used as the adhesion strengthening layer.

A step U of forming an adhesion strengthening layer between the ceramic layer and the iron-based metal or Cr layer may also be provided as a step between the step C and the step G. The adhesion between the ceramic layer and the iron-based metal or Cr layer is thereby significantly enhanced, and as a result, the process yield is markedly enhanced. A Ti layer, for example, may be suitably used as the adhesion strengthening layer.

The method for manufacturing a diamond electron source according to the present invention may further comprise a step V of using a focused ion beam device to adjust a shape of the sharpened tip to a rotationally symmetrical shape. In the steps F, K, O, Q, and S, the shape of the sharpened tip formed by dry etching the pillar-shaped diamond monocrystal is not necessarily the required rotationally symmetrical shape for obtaining a high-quality electron beam, due to roughness and the like of the surface. In this case, adding the step V makes it possible to recover processing defects, and as a result, the process yield is markedly enhanced.

A step W of removing damage due to surface processing by exposing the sharpened tip to hydrogen plasma or a high-temperature hydrogen atmosphere may also be provided. In the steps F, K, O, Q, S, and V, a layer of damage due to ion impact is present on the surface of the sharpened tip formed at one end of the pillar-shaped diamond monocrystal, and the natural electron emission ability of the diamond therefore sometimes cannot be demonstrated. At this time, since the damage layer is removed by exposing the sharpened tip to hydrogen plasma or a high-temperature hydrogen atmosphere, the electron emission ability is restored. The high-temperature hydrogen atmosphere is preferably 300°C or higher to efficiently remove the damage layer.

In the method for manufacturing a diamond electron source according the present invention, the ceramic layer is preferably any of SiO₂, SiON, SiOₓ, Al₂O₃, and AlOₓ. When these compounds are used, the retreat of the ceramic mask can be utilized to efficiently sharpen the end of the diamond in a satisfactory shape in the step F or K, and as a result, a diamond electron source having excellent performance is obtained.

The thin-film layer formed in step D and step H of the methods according to the first and second aspects is preferably W (tungsten). When the thin-film layer is W (tungsten), a W (tungsten) thin film in an arbitrary shape can easily be formed by using an FIB to radiate a Ga ion beam while blowing W(CO)₆ gas, for example, and the diamond electron source fabrication process is therefore facilitated.

Furthermore, the thin-film layer in the step D of the method according to the first aspect may be Ni. In an FIB, an Ni thin film in an arbitrary shape can be formed by radiating a Ga ion beam while blowing Ni(CO)₄ gas, for example. In the dry etching of the step E, a metal layer having high selectivity with respect to the ceramic layer is necessary according to the shape of the sharpened tip to be formed, but Ni often has high selectivity with respect to the ceramic layer. When the selectivity is high, since the range of thicknesses of the ceramic layer that can be etched increases, the range of thicknesses of the ceramic layer that can be selected increases in etching of the diamond monocrystal in the step F. Specifically, through the use of an Ni layer fabricated by an FIB as the metal layer, the fabrication process of the diamond electron source is made easier, and the sharpened tip can be fabricated in a wider variety of shapes.

The iron-based metal layer used in the method according to the second aspect is preferably any of Fe, Ni, Co, and an alloy that includes Fe, Ni, or Co. When the ceramic layer is dry etched using a metal layer as the mask, a metal layer having high selectivity with respect to the ceramic layer is necessary according to the shape of the sharpened tip to be formed, but Fe, Ni, Co, or an alloy that includes Fe, Ni, or Co often has high selectivity with respect to the ceramic layer, in the same manner as Cr. When the selectivity is high, since the range of thicknesses of the ceramic layer that can be etched increases, the range of thicknesses of the ceramic layer that can be selected increases in etching of the diamond monocrystal in the step K. Specifically, by selecting Fe, Ni, Co, or an alloy that includes Fe, Ni, or Co, the fabrication process of the diamond electron source is made easier, and the sharpened tip can be fabricated in a wider variety of shapes.

The iron-based metal layer used in the method according to the third aspect is preferably any of Fe, Ni, Co, and an alloy that includes Fe, Ni, or Co. When these metals are used, the retreat of the iron-based metal mask can be utilized in the same manner as the Cr mask to efficiently sharpen the end of the diamond in a satisfactory shape in the step O. Since the iron-based metal mask has higher selectivity than the ceramic mask with respect to the diamond in dry etching, a higher sharpened tip can be formed, and as a result, a diamond electron source having more excellent performance is obtained.

The size of the pillar-shaped diamond monocrystal may be within a cubic space from 50 µm × 50 µm × 100 µm to 1 mm × 1 mm × 5 mm. When the size of the diamond monocrystal is within this range, the fabricated diamond electron source is interchangeable with an LaB₆, ZrO/W, or other conventional point electron source, and as a result, the diamond electron source can be used in a wide range of electron beam devices. Compatibility is difficult to provide outside of the abovementioned size range.

At least a portion of the pillar-shaped diamond monocrystal may include 1 × 10¹⁷ cm⁻³ or more of a donor impurity or an acceptor impurity. Adequate conductivity is obtained by including a donor or acceptor impurity in this manner, and as a result, a diamond electron source having high brightness is obtained. However, when less than 1 × 10¹⁷ cm⁻³ of the impurity is included, an electron source having satisfactory performance in practical terms cannot be obtained.

The size of the smooth flat surface formed by grinding one end of the pillar-shaped diamond monocrystal is preferably a diameter of 10 µm or more. When the size of the smooth flat surface is a diameter of 10 µm or more, a sharpened tip that has enables practical performance as an electron source can be obtained through the subsequent manufacturing steps.

The thickness of the ceramic layer or the SiOₓ layer is preferably 1 µm or greater. When the thickness is 1 µm or greater, an adequate height of the sharpened tip can be obtained, and the electric field concentration on the sharpened tip is therefore increased when electrons are emitted by an electric field from the completed diamond electron source. As a result, a diamond electron source having higher brightness is obtained.

The thickness of the adhesion strengthening layer is preferably in a range from 10 to 100 nm. The object of enhancing adhesion is achieved when the thickness of the adhesion strengthening layer is in the range of 10 to 100 nm, and as a result, the process yield is markedly enhanced. A Ti layer, for example, may be suitably used as the adhesion strengthening layer.

Furthermore, the sharpened tip preferably has a height of 10 µm or more and a distal-end radius or distal-end curvature radius of 10 µm or less. The diamond electron source has practical performance as an electron source by having such a distal end shape.

The diamond electron source of the present invention is characterized in comprising a pillar-shaped diamond monocrystal having a size within a cubic space from 50 µm × 50 µm × 100 µm to 1 mm × 1 mm × 5 mm, wherein one end of the pillar-shaped diamond monocrystal is a smooth flat surface having a sharpened tip that has a height of 10 µm or more and a distal-end radius or distal-end curvature radius of 10 µm or less on the flat surface. Through the use of such a shape, the present invention can be interchangeable with an LaB₆, ZrO/W, or other conventional electron source, and the present invention can therefore be easily installed in a conventionally used electron microscope, electron beam exposure device, or other electron beam device. An electron beam having higher brightness than the conventional electron source can be obtained by installing the diamond electron source of the present invention. Outside of the abovementioned range, compatibility is difficult to provide, or the brightness is low, and practical electron source performance is not obtained.

The diamond electron source may also be characterized in that one end of the pillar-shaped diamond monocrystal is a pointed shape having a smooth flat surface at an apex, a size of the flat surface is a diameter of 10 µm or more, and the flat surface has a sharpened tip that has a height of 10 µm or more and a distal-end radius or distal-end curvature radius of 10 µm or less. Through the use of such a shape, an electron beam having even higher brightness can be obtained.

The diamond electron source may also be characterized in that at least a portion thereof includes 1 × 10¹⁷ cm⁻³ or more of a donor impurity or an acceptor impurity. Adequate conductivity is obtained by including a donor or acceptor impurity in this manner, and as a result, a diamond electron source having high brightness is obtained.

Because the diamond electron source of the present invention has such a shape and qualities as those described above, a high-brightness electron beam can be obtained, and the diamond electron source of the present invention is characterized in that an electron beam is obtained having an angular current density of 0.2 mA/sr or higher. Since the effective work function of the diamond electron source of the present invention is small, an electron beam having small energy dispersion and high convergence can be produced. Therefore, the present invention may also be characterized in that an electron beam is obtained having an angular current density of 0.2 mA/sr or higher and an energy dispersion having a FWHM (Full Width at Half Maximum) of 1.0 eV or less.

Furthermore, at least a portion of the diamond monocrystal includes 1 × 10¹⁸ cm⁻³ or more of a donor impurity, whereby the operating temperature of the diamond electron source of the present invention can be further reduced. Therefore, an electron beam having small energy dispersion and high convergence can be produced, and an electron beam can be obtained that has an angular current density of 0.2 mA/sr or higher and an energy dispersion having a FWHM of 0.5 eV or less. An electron beam having higher brightness can be produced by making the distal end radius or distal-end curvature radius of the distal end part 1 µm or less. Therefore, an electron beam can be obtained that has an angular current density of 1 mA/sr or higher and an energy dispersion having a FWHM of 0.9 eV or less. Effect of the Invention

According to the present invention, through the use of a thin-film deposition technique using a focused ion beam device (FIB), a micron-sized or smaller sharpened tip can be formed by ion etching on one end of a pillar-shaped diamond monocrystal of a size for which resist application is difficult, and a high-brightness diamond electron source can be provided. Consequently, by mounting this diamond electron source in an electron beam device, an electron microscope capable of high-magnification observation, an electron beam exposure device capable of drawing a minute pattern at high throughput, or the like can be obtained.

### BRIEF DESCRIPTION OF THE DRAWINGS

FIG. 1A is a schematic perspective view showing the pillar-shaped diamond monocrystal on which a smooth flat surface is formed in step B of Embodiment 1, and shows a state in which sharpening is performed only in step B;
FIG. 1B is a schematic perspective view showing the pillar-shaped diamond monocrystal on which a smooth flat surface is formed in step B of Embodiment 1, and shows a state in which sharpening is performed only in step B and step N;
FIG. 2A is a schematic sectional view showing the pillar-shaped diamond monocrystal in which the ceramic layer is formed on the smooth flat layer in step C of Embodiment 1, and shows a state in which the adhesion strengthening layer is provided only in step C;
FIG. 2B is a schematic sectional view showing the pillar-shaped diamond monocrystal in which the ceramic layer is formed on the smooth flat layer in step C of Embodiment 1, and shows a state in which the adhesion strengthening layer is provided in step C and step U;
FIG. 3A is a schematic sectional view showing the pillar-shaped diamond monocrystal in which the thin-film layer is formed on the ceramic layer in step D of Embodiment 1, and shows the state of only step D;
FIG. 3B is a schematic sectional view showing the pillar-shaped diamond monocrystal in which the thin-film layer is formed on the ceramic layer in step D of Embodiment 1, and is a plan view of FIG. 3A;
FIG. 3C is a schematic sectional view showing the pillar-shaped diamond monocrystal in which the thin-film layer is formed on the ceramic layer in step D of Embodiment 1, and shows a state in which the adhesion strengthening layer is provided in step D as well as step U;
FIG. 4A is a schematic sectional view showing the pillar-shaped diamond monocrystal in which the ceramic mask is formed in step E of Embodiment 1, and shows a case in which wet etching is used;
FIG. 4B is a schematic sectional view showing the pillar-shaped diamond monocrystal in which the ceramic mask is formed in step E of Embodiment 1, and shows a case in which dry etching is used;
FIG. 5 is a schematic sectional view showing the pillar-shaped diamond monocrystal in which the sharpened tip is formed in step F of Embodiment 1;
FIG. 6A is a schematic perspective view showing the pillar-shaped diamond monocrystal in which the smooth flat surface is formed in step B of Embodiment 2, and shows a state in which sharpening is performed only in step B;
FIG. 6B is a schematic perspective view showing the pillar-shaped diamond monocrystal in which the smooth flat surface is formed in step B of Embodiment 2, and shows a state in which sharpening is performed in step B and step N;
FIG. 7A is a schematic sectional view showing the pillar-shaped diamond monocrystal in which the ceramic layer is formed on the smooth flat layer in step C of Embodiment 2, and shows a state in which the adhesion strengthening layer is provided only in step C;
FIG. 7B is a schematic sectional view showing the pillar-shaped diamond monocrystal in which the ceramic layer is formed on the smooth flat layer in step C of Embodiment 2, and shows a state in which the adhesion strengthening layer is provided in step C and step U;
FIG. 8A is a schematic sectional view showing the pillar-shaped diamond monocrystal in which the iron-based metal or Cr layer is formed on the ceramic layer in step G of Embodiment 2, and shows a state in which the adhesion strengthening layer is provided only in step G;
FIG. 8B is a schematic sectional view showing the pillar-shaped diamond monocrystal in which the iron-based metal or Cr layer is formed on the ceramic layer in step G of Embodiment 2, and shows a state in which the adhesion strengthening layer is provided in step G and step U;
FIG. 9A is a schematic sectional view showing the pillar-shaped diamond monocrystal in which the thin-film layer is formed on the iron-based metal or Cr layer in step H of Embodiment 2, and shows the state after step H;
FIG. 9B is a schematic sectional view showing the pillar-shaped diamond monocrystal in which the thin-film layer is formed on the iron-based metal or Cr layer in step H of Embodiment 2, and is a plan view of FIG. 9A;
FIG. 10 is a schematic sectional view showing the pillar-shaped diamond monocrystal in which the iron-based metal or Cr mask is formed in step I of Embodiment 2;
FIG. 11A is a schematic sectional view showing the pillar-shaped diamond monocrystal in which the ceramic mask is formed in step J of Embodiment 2, and shows a case of wet etching;
FIG. 11B is a schematic sectional view showing the pillar-shaped diamond monocrystal in which the ceramic mask is formed in step J of Embodiment 2, and shows a case of dry etching;
FIG. 12 is a schematic sectional view showing the pillar-shaped diamond monocrystal in which the sharpened tip is formed in step K of Embodiment 2;
FIG. 13A is a schematic perspective view showing the pillar-shaped diamond monocrystal on which a smooth flat surface is formed in step B of Embodiment 3, and shows a state in which sharpening is performed only in step B;
FIG. 13B is a schematic perspective view showing the pillar-shaped diamond monocrystal on which a smooth flat surface is formed in step B of Embodiment 3, and shows a state in which sharpening is performed in step B and step N;
FIG. 14 is a schematic sectional view showing the pillar-shaped diamond monocrystal in which the iron-based metal or Cr layer is formed on the smooth flat surface in step L of Embodiment 3;
FIG. 15A is a schematic sectional view showing the pillar-shaped diamond monocrystal in which the thin-film layer is formed on the iron-based metal or Cr layer in step M of Embodiment 3, and shows the state after step M;
FIG. 15B is a schematic sectional view showing the pillar-shaped diamond monocrystal in which the thin-film layer is formed on the iron-based metal or Cr layer in step M of Embodiment 3, and is a plan view of FIG. 15A;
FIG. 16A is a schematic sectional view showing the pillar-shaped diamond monocrystal in which the iron-based metal or Cr mask is formed in step N of Embodiment 3, and shows a case in which wet etching is used;
FIG. 16B is a schematic sectional view showing the pillar-shaped diamond monocrystal in which the iron-based metal or Cr mask is formed in step N of Embodiment 3, and shows a case in which dry etching is used;
FIG. 17 is a schematic sectional view showing the pillar-shaped diamond monocrystal in which the sharpened tip is formed in step O of Embodiment 3;
FIG. 18A is a schematic perspective view showing the pillar-shaped diamond monocrystal on which a smooth flat surface is formed in step B of Embodiment 4, and shows a state in which sharpening is performed only in step B;
FIG. 18B is a schematic perspective view showing the pillar-shaped diamond monocrystal on which a smooth flat surface is formed in step B of Embodiment 4, and shows a state in which sharpening is performed in step B and step N;
FIG. 19A is a schematic sectional view showing the pillar-shaped diamond monocrystal in which the SiOₓ layer is formed on the smooth flat surface in step P of Embodiment 4, and shows the state of only the columnar SiOₓ layer of step P;
FIG. 19B is a schematic sectional view showing the pillar-shaped diamond monocrystal in which the SiOₓ layer is formed on the smooth flat surface in step P of Embodiment 4, and shows a state in which the adhesion strengthening layer is provided by only the columnar SiOₓ layer of step P;
FIG. 19C is a schematic sectional view showing the pillar-shaped diamond monocrystal in which the SiOₓ layer is formed on the smooth flat surface in step P of Embodiment 4, and shows a state in which the adhesion strengthening layer is provided by step U and the columnar SiOₓ layer of step P;
FIG. 20 is a schematic sectional view showing the pillar-shaped diamond monocrystal in which the sharpened tip is formed in step Q of Embodiment 4;
FIG. 21A is a schematic perspective view showing the pillar-shaped diamond monocrystal on which a smooth flat surface is formed in step B of Embodiment 5, and shows a state in which sharpening is performed only in step B;
FIG. 21B is a schematic perspective view showing the pillar-shaped diamond monocrystal on which a smooth flat surface is formed in step B of Embodiment 5, and shows a state in which sharpening is performed in step B and step N;
FIG. 22A is a schematic sectional view showing the pillar-shaped diamond monocrystal in which the Ni layer is formed on the smooth flat surface in step R of Embodiment 5, and shows a state in which the columnar Ni layer of step R is formed;
FIG. 22B is a schematic sectional view showing the pillar-shaped diamond monocrystal in which the Ni layer is formed on the smooth flat surface in step R of Embodiment 5, and shows a state in which the columnar Ni layer of step R is formed;
FIG. 23 is a schematic sectional view showing the pillar-shaped diamond monocrystal in which the sharpened tip is formed in step S of Embodiment 5;
FIG. 24A is a 500x-magnification electron micrograph of the diamond electron source of the present invention fabricated in Example 3; and
FIG. 24B is a 3000x-magnification electron micrograph of the diamond electron source of the present invention fabricated in Example 3.

### Key to Symbols

- 10, 20, 30, 40, 50: pillar-shaped diamond monocrystal
- 11, 21, 31, 41, 51: smooth flat surface
- 12, 22: ceramic layer
- 13, 15, 23, 25, 43: adhesion strengthening layer
- 14, 26, 34: thin-film layer
- 16, 28: ceramic mask
- 17, 29, 36, 44, 53: sharp end part
- 24, 32: iron-based metal or Cr layer
- 27, 35: iron-based metal or Cr mask
- 42: SiOₓ layer
- 52: Ni layer

### BEST MODES FOR CARRYING OUT THE INVENTION

Preferred embodiments of the method for manufacturing a diamond electron source according to the present invention will be described in detail with reference to the drawings. The same reference symbols are used in the drawings to refer to the same elements, and no redundant description is given. The dimensional ratios in the drawings do not necessarily match the description. The present invention is not limited by the embodiments described below, and modifications and other embodiments based on the technical scope of the present invention are also encompassed by the present invention.

### (Embodiment 1)

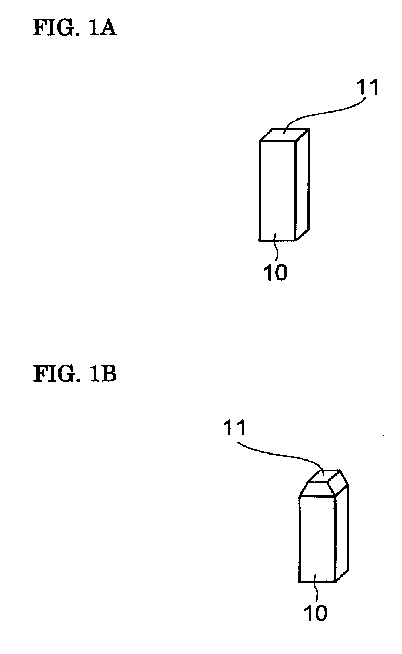

Embodiment 1 of the present invention will be described with reference to FIGS. 1 through 5. First, in step A, a pillar-shaped diamond monocrystal is prepared in a size for which resist application is difficult in a microfabrication process. A rectangular solid shape is preferred for use as the shape of the pillar-shaped diamond monocrystal. Specifically, in the six sides constituting the rectangular solid, the preferred monocrystal is a monocrystal in which all six sides are (100) planes (off angle within 7°), a monocrystal in which four sides are (110) planes (off angle within 7°) and two sides are (100) planes (off angle within 7°), or a monocrystal in which two sides are (110) planes (off angle within 7°), two sides are (211) planes (off angle within 7°), and two sides are (111) planes (off angle within 7°).

A pillar-shaped diamond monocrystal having a size within a cubic space from 50 µm × 50 µm × 100 µm to 1 mm × 1 mm × 5 mm can be suitably used. When the size is less than 50 µm × 50 µm × 100 µm or larger than 1 mm × 1 mm × 5 mm, the pillar-shaped diamond monocrystal is difficult to install in an electron microscope, electron beam exposure device, or other electron beam device. In order to obtain adequate conductivity as an electron source, at least a portion preferably includes a donor or acceptor impurity in an amount of 1 × 10¹⁷ cm⁻³ or more. The donor impurity is preferably P (phosphorus), and the acceptor impurity is preferably B (boron). Specifically, it is possible to appropriately use a diamond monocrystal in which a P-doped diamond thin film or a B-doped diamond thin film is epitaxially grown on a diamond monocrystal synthesized at high temperature and high pressure, or to use a vapor-phase synthetic B-doped diamond monocrystal, a high-temperature high-pressure synthetic B-containing diamond monocrystal, or the like.

At least one end of the pillar-shaped diamond monocrystal is then ground in step B, and a smooth flat surface 11 is formed on one end of the pillar-shaped diamond monocrystal 10, as shown in FIG. 1. The size of the smooth flat surface 11 is preferably a diameter of 10 µm or more in order to form a sufficiently large (high) sharpened tip as an electron source on the smooth flat surface 11 in a subsequent step. The surface roughness Ra of the smooth flat surface 11 is preferably 100 nm or less. When the surface roughness is more than 100 nm, the surface of the electron emission point of the sharpened tip formed in a subsequent step is rough, and adequate brightness as a diamond electron source is not obtained.

The smooth flat surface 11 may be formed on the entire surface of one end of the pillar-shaped diamond monocrystal 10, as shown in FIG. 1A, or the side surfaces of one end may be ground as shown in FIG. 1B, and a tapered end shape (substantially truncated-pyramid shape) having the smooth flat surface 11 on the apex part may be formed. The grinding for forming the sharp end shape (step T) may be performed immediately before or immediately after step B. Through providing the smooth flat surface 11 at the apex of such a tapered end shape, the field concentration increases at the sharpened tip ultimately obtained, and a diamond electron source having higher brightness is obtained.

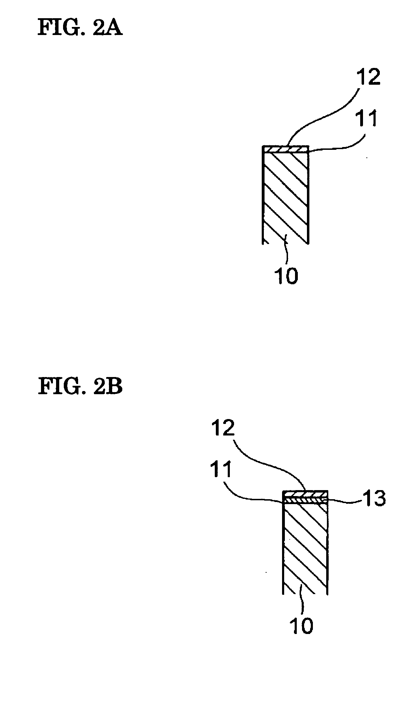

In step C, a ceramic layer 12 is formed on the smooth flat surface 11, as shown in FIG. 2A. The ceramic layer 12 preferably has quality whereby the retreat of the mask can be utilized to efficiently sharpen the end of the diamond in a satisfactory shape when the diamond is subsequently etched using the ceramic mask, and specific compounds that may be suitably used include SiO₂, SiON, SiOₓ, Al₂O₃, AlOₓ, and the like. The thickness of the ceramic layer 12 is preferably 1 µm or more when sharpening of the diamond using the ceramic layer 12 as a mask is considered. When the thickness is less than 1 µm, it is difficult to form a sharp end protrusion that is adequately high for obtaining high brightness in comparison to the conventional electron source. Sputtering, CVD, or another thin film formation device may be suitably used to form the ceramic layer 12.

An adhesion strengthening layer 13 may be formed between the ceramic layer 12 and the pillar-shaped diamond monocrystal 10 as shown in FIG. 2B (step U). Adhesion between the smooth flat surface 11 and the ceramic layer 12 is enhanced by the adhesion strengthening layer 13, but a thickness range of 10 to 100 nm for the adhesion strengthening layer 13 is appropriate in order to obtain enhanced adhesion. The adhesion enhancing effects are not obtained when the thickness is less than 10 nm, and when the thickness exceeds 100 nm, the adhesion strengthening layer impedes subsequent etching of the diamond using the ceramic layer 12 as a mask. A Ti layer may be suitably used as the adhesion strengthening layer 13.

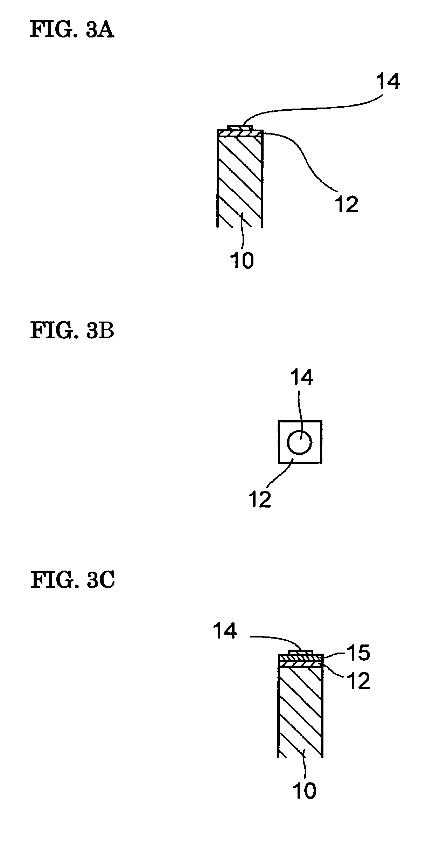

A thin-film layer 14 having a prescribed shape is then deposited on the ceramic layer 12 using a focused ion beam device (FIB) in step D, as shown in FIG. 3A. The elements W (tungsten), Pt (platinum), and C (carbon), which are easily deposited using an FIB device, can be suitably used as the thin-film layer 14. Ni having high etching selectivity with respect to the ceramic layer 12 during dry etching may also be used as needed. Since Ni has high etching selectivity with respect to the ceramic layer 12, a thicker ceramic layer 12 can be patterned, and as a result, a higher sharpened tip of the diamond can be fabricated.

The thin-film layer 14 is deposited using an FIB device, and may therefore have any shape, but from the perspective of an electron source, the shape of the sharpened tip after sharpening of the diamond is preferably rotationally symmetrical, and the shape of the ceramic layer used as the mask is therefore preferably rotationally symmetrical. Specifically, the shape of the thin-film layer 14 for patterning the ceramic layer 12 is preferably circular, as shown in FIG. 3B. The thin-film layer 14 is also preferably disposed in the center of the surface of the ceramic layer 12. The diamond sharpened tip after fabrication is thereby disposed on the substantial center axis of the pillar-shaped diamond monocrystal 10, and advantages are thereby obtained in that the optical axis is easily aligned when the diamond electron source is mounted in an electron beam device.

An adhesion strengthening layer 15 may be formed between the thin-film layer 14 and the ceramic layer 12, as shown in FIG. 3C (step U). Adhesion between the ceramic layer 12 and the thin-film layer 14 is enhanced by the adhesion strengthening layer 15, but a thickness range of 10 to 100 nm for the adhesion strengthening layer 15 is appropriate in order to obtain enhanced adhesion. The adhesion enhancing effects are not obtained when the thickness of the adhesion strengthening layer 15 is less than 10 nm, and when the thickness exceeds 100 nm, the adhesion strengthening layer impedes etching of the ceramic layer 12 by using the thin-film layer 14 as a mask. A Ti layer, for example, may be suitably used as the adhesion strengthening layer 15.

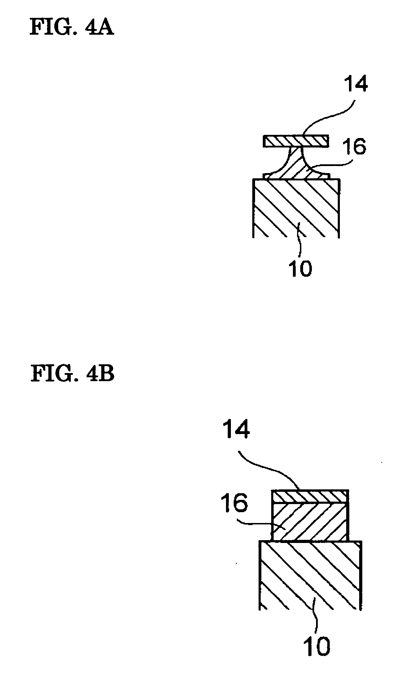

In the next step E, the ceramic layer 12 is etched by wet etching or dry etching using the thin-film layer 14 as a mask formed in a prescribed shape using an FIB device in step D, and a patterned ceramic mask 16 is fabricated, as shown in FIG. 4. When wet etching is selected at this time, since etching proceeds in isotropic fashion, the ceramic layer 12 becomes a peak-shaped ceramic mask 16 such as the one shown in FIG. 4A. When reactive ion etching (RIE) or another dry etching technique is selected, since the region directly below the thin-film layer 14 is not easily etched, the ceramic layer 12 becomes a cylindrical ceramic mask 16 such as the one shown in FIG. 4B. The metal layer 14 may be removed after etching is completed.

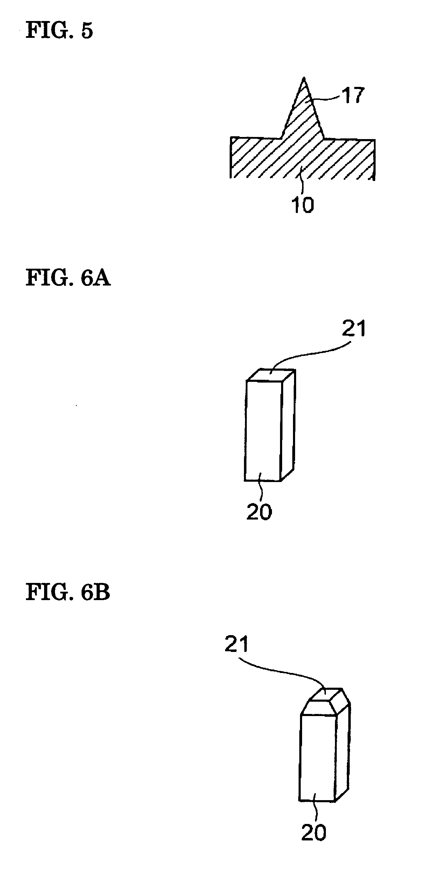

One end of the pillar-shaped diamond monocrystal 10 is then sharpened by RIE or another dry etching technique in step F using the ceramic mask 16. In step F, a single sharpened tip 17 may be formed at one end of the pillar-shaped diamond monocrystal 10 as shown in FIG. 5. The sharpened tip 17 preferably has a height of 10 µm or more, and a distal-end radius or distal-end curvature radius of 10 µm or less. Such a distal end shape produces a diamond electron source having practical performance as an electron source.

Furthermore, the shape of the sharpened tip 17 obtained as described above may be adjusted to a rotationally symmetrical shape using a focused ion beam device (step V). The shape of the sharpened tip 17 after etching of the pillar-shaped diamond monocrystal does not necessarily have the rotational symmetry necessary for obtaining a high-quality electron beam, due to surface roughness or the like. Therefore, when a focused ion beam device is used to create a rotationally symmetrical shape as needed, fabrication defects can be recovered, the process yield is markedly enhanced, and an electron source having higher brightness can therefore be obtained.

Since the sharpened tip 17 is damaged by ion impacts from RIE, FIB fabrication, and the like, the layer of damage on the surface can be removed through exposure to hydrogen plasma or a high-temperature hydrogen atmosphere (step W). The normal electron emission ability of diamond is obtained by removing the surface damage layer of the sharpened tip, and a high-brightness electron source can be obtained as a result. When a high-temperature hydrogen atmosphere is used, the use of a hydrogen atmosphere at 300°C or higher makes it possible to efficiently remove the damage layer.

### (Embodiment 2)

Embodiment 2 of the present invention will be described with reference to FIGS. 6 through 12. First, in step A, a pillar-shaped diamond monocrystal, preferably a rectangular pillar-shaped diamond monocrystal, is prepared in a size for which resist application is difficult in a microfabrication process, in the same manner as in Embodiment 1. Specifically, in the six sides constituting the rectangular solid, the preferred monocrystal is a monocrystal in which all six sides are (100) planes (off angle within 7°), a monocrystal in which four sides are (110) planes (off angle within 7°) and two sides are (100) planes (off angle within 7°), or a monocrystal in which two sides are (110) planes (off angle within 7°), two sides are (211) planes (off angle within 7°), and two sides are (111) planes (off angle within 7°).

A pillar-shaped diamond monocrystal having a size within a cubic space from 50 µm × 50 µm × 100 µm to 1 mm × 1 mm × 5 mm can be suitably used. When the size is less than 50 µm × 50 µm × 100 µm or larger than 1 mm × 1 mm × 5 mm, the pillar-shaped diamond monocrystal is difficult to install in an electron microscope, electron beam exposure device, or other electron beam device. In order to obtain adequate conductivity as an electron source, at least a portion preferably includes a donor or acceptor impurity in an amount of 1 × 10¹⁷ cm⁻³ or more. The donor impurity is preferably P, and the acceptor impurity is preferably B. Specifically, it is possible to appropriately use a diamond monocrystal in which a P-doped diamond thin film or a B-doped diamond thin film is epitaxially grown on a diamond monocrystal synthesized at high temperature and high pressure, or to use a vapor-phase synthetic B-doped diamond monocrystal, a high-temperature high-pressure synthetic B-containing diamond monocrystal, or the like.

At least one end of the pillar-shaped diamond monocrystal is then ground in step B, and a smooth flat surface 21 is formed on one end of the pillar-shaped diamond monocrystal 20, as shown in FIG. 6. The size of the smooth flat surface 21 is preferably a diameter of 10 µm or more in order to form a sufficiently large (high) sharpened tip as an electron source on the smooth flat surface 21 in a subsequent step. The surface roughness Ra of the smooth flat surface 21 is preferably 100 nm or less. When the surface roughness is more than 100 nm, the surface of the electron emission point of the sharpened tip formed in a subsequent step is rough, and adequate brightness as a diamond electron source is not obtained.

The smooth flat surface 21 may be formed on the entire surface of one end of the pillar-shaped diamond monocrystal 20, as shown in FIG. 6A, or the side surfaces of one end may be ground as shown in FIG. 6B, and a tapered end shape (substantially truncated-pyramid shape) having the smooth flat surface 21 on the apex part may be formed. The grinding for forming the sharp end shape (step T) may be performed immediately before or immediately after step B. Through providing the smooth flat surface 21 at the apex of such a tapered end shape, the field concentration increases at the sharpened tip ultimately obtained, and a diamond electron source having higher brightness is obtained.

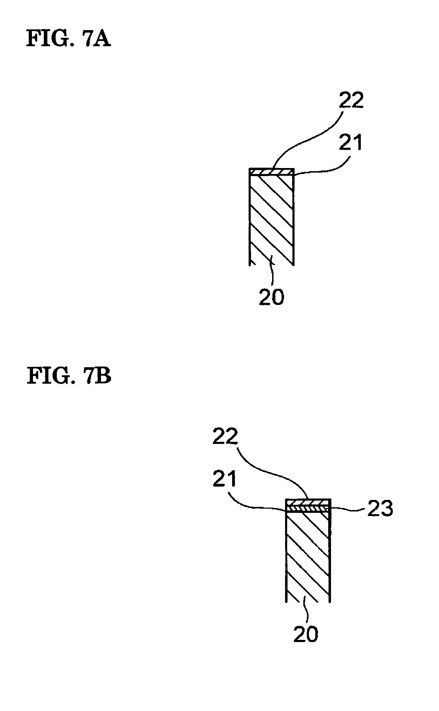

In step C, a ceramic layer 22 is formed on the smooth flat surface 21, as shown in FIG. 7A. The ceramic layer 22 preferably has quality whereby the retreat of the mask can be utilized to efficiently sharpen the end of the diamond in a satisfactory shape when the diamond is subsequently etched using the ceramic mask, and specific compounds that may be suitably used include SiO₂, SiON, SiOₓ, Al₂O₃, AlOₓ, and the like. The thickness of the ceramic layer 22 is preferably 1 µm or more when sharpening of the diamond using the ceramic layer 22 as a mask is considered. When the thickness is less than 1 µm, it is difficult to form a sharp end protrusion that is adequately high for obtaining high brightness in comparison to the conventional electron source. Sputtering, CVD, or another thin film formation device may be suitably used to form the ceramic layer 22.

An adhesion strengthening layer 23 may be formed between the ceramic layer 22 and the pillar-shaped diamond monocrystal 20 as shown in FIG. 7B (step U). Adhesion between the smooth flat surface 21 and the ceramic layer 22 is enhanced by the adhesion strengthening layer 23, but a thickness range of 10 to 100 nm for the adhesion strengthening layer 23 is appropriate in order to obtain enhanced adhesion. The adhesion enhancing effects are not obtained when the thickness is less than 10 nm, and when the thickness exceeds 100 nm, the adhesion strengthening layer impedes subsequent etching of the diamond using the ceramic layer 22 as a mask. A Ti layer may be suitably used as the adhesion strengthening layer 23.

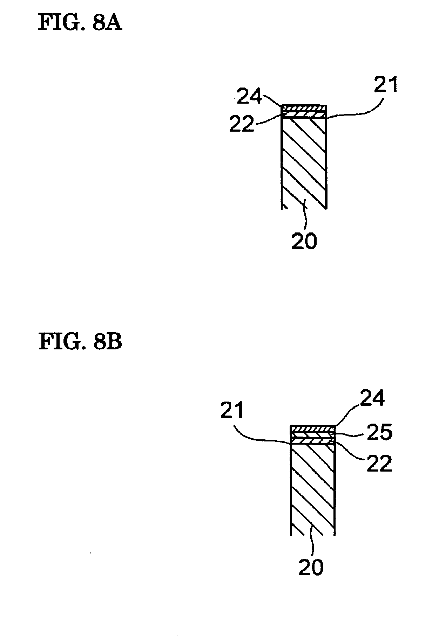

An iron-based metal or Cr layer 24 is then formed on the ceramic layer 22 in step G, as shown in FIG. 8A. Metals that are suitable for use as the iron-based metal layer include Fe, Ni, Co, and alloys that include these metals. A thick ceramic layer 22 is sometimes necessary in order to make the sharpened tip adequately high to efficiently produce electrons through the use of an electric field. A metal having high etching selectivity with respect to the ceramic layer 22 is useful for patterning a thick ceramic layer 22 by dry etching. Since the abovementioned iron-based metal or Cr has relatively high selectivity, a wider range of shapes for the sharpened tip can be fabricated by etching the ceramic layer 22 using the iron-based metal or Cr as a mask. The iron-based metal or Cr layer 24 may be formed by sputtering, CVD, vapor deposition, or the like.

An adhesion strengthening layer 25 may be formed between the ceramic layer 22 and the iron-based metal or Cr layer 24 as shown in FIG. 8B (step U). Adhesion between the ceramic layer 22 and the iron-based metal or Cr layer 24 is enhanced by the adhesion strengthening layer 25, but the adhesion enhancing effects are not obtained when the thickness of the adhesion strengthening layer 25 is less than 10 nm. When the thickness of the adhesion strengthening layer 25 exceeds 100 nm, the adhesion strengthening layer impedes etching of the ceramic layer 22 using the iron-based metal or Cr layer 24 as a mask. A Ti layer, for example, may be suitably used as the adhesion strengthening layer 25.

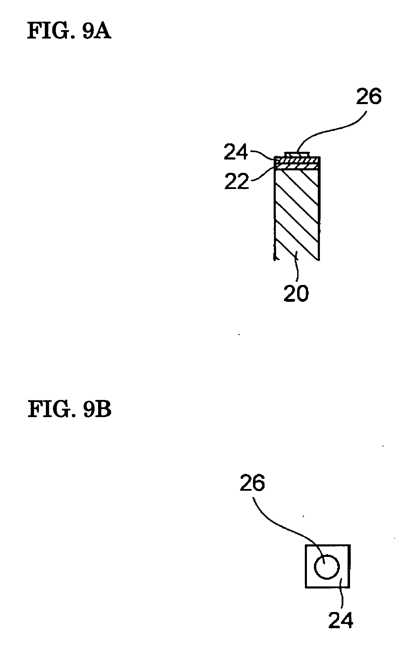

A thin-film layer 26 having a prescribed shape is then deposited on the iron-based metal or Cr layer 24 using a focused ion beam device (FIB) in step H, as shown in FIG. 9A. The elements W (tungsten), Pt (platinum), and C (carbon), which are easily deposited using an FIB device, can be suitably used as the thin-film layer 26. The thin-film layer 26 is deposited using an FIB device, and may therefore have any shape, but from the perspective of an electron source, the shape of the sharpened tip after sharpening of the diamond is preferably rotationally symmetrical, and the shapes of the ceramic layer used as the mask, and the iron-based metal or Cr layer for patterning the ceramic layer are therefore preferably rotationally symmetrical.

Specifically, the shape of the thin-film layer 26 for patterning the iron-based metal or Cr layer 24 is preferably circular, as shown in FIG. 9B. The thin-film layer 26 is also preferably disposed in the center of the surface of the iron-based metal or Cr layer 24. The sharpened tip after fabrication is thereby disposed on the substantial center axis of the pillar-shaped diamond monocrystal, and the optical axis is therefore easily aligned when the diamond electron source is mounted in an electron beam device.

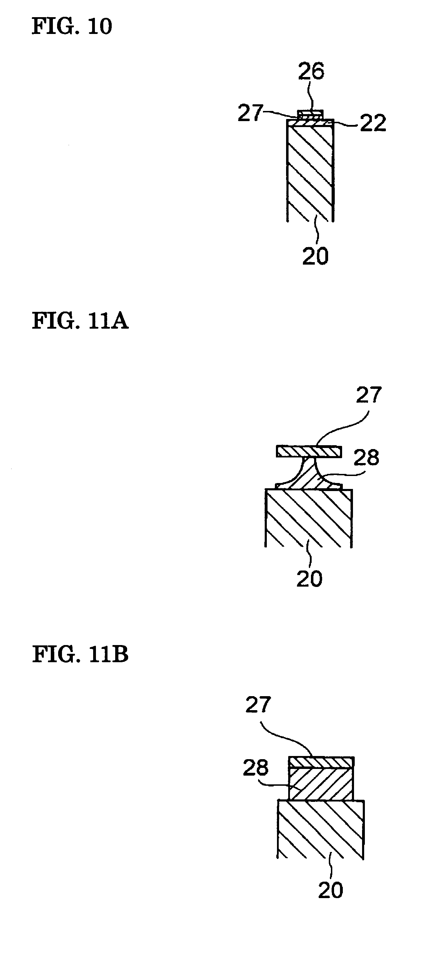

The iron-based metal or Cr layer 24 is then etched in step I by wet etching or dry etching using the thin-film layer 26 having the abovementioned prescribed shape as a mask, and a patterned iron-based metal or Cr mask 27 is formed, as shown in FIG. 10.

The ceramic layer 22 is then etched and patterned in step J by wet etching or dry etching using the iron-based metal or Cr mask 27. At this time, since etching proceeds in isotropic fashion when wet etching is selected, the ceramic layer 22 becomes a peak-shaped ceramic mask 28 such as the one shown in FIG. 11A. In this case, an iron-based metal or Cr need not be selected, and Mo, Ta, or another metal, for example, may be used. When RIE or another dry etching technique is selected, since the region directly below the iron-based metal or Cr mask 27 is not easily etched, the ceramic layer 22 becomes a cylindrical ceramic mask 28 such as the one shown in FIG. 11B. In this case, Ni or another iron-based metal or Cr having high etching selectivity with the ceramic layer is preferred. The thin-film layer 26 may be removed prior to the start of etching, but is usually removed after etching is completed. The iron-based metal or Cr mask 27 is also removed when etching is completed.

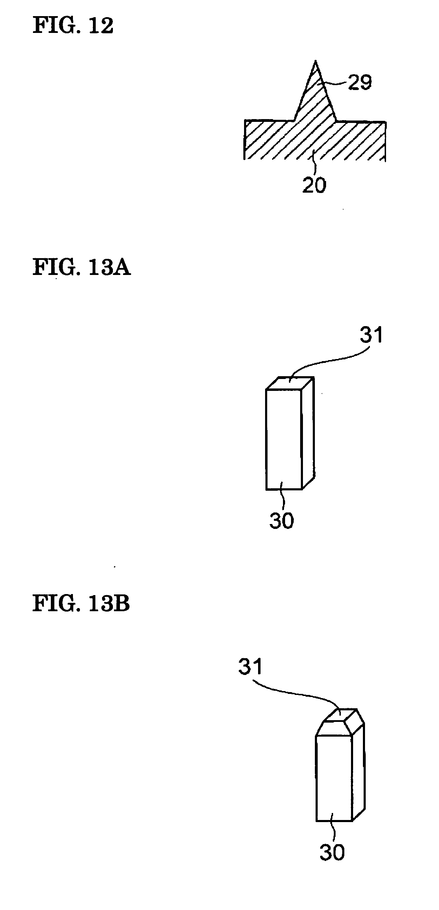

One end of the pillar-shaped diamond monocrystal 20 is then sharpened by RIE or another dry etching technique in step K using the ceramic mask 28. In step K, a single sharpened tip 29 may be formed at one end of the pillar-shaped diamond monocrystal 20 as shown in FIG. 12. The sharpened tip 29 preferably has a height of 10 µm or more, and a distal-end radius or distal-end curvature radius of 10 µm or less. Such a distal end shape produces a diamond electron source having practical performance as an electron source.

Furthermore, the shape of the sharpened tip 29 obtained as described above may be adjusted to a rotationally symmetrical shape using a focused ion beam device (step V). The shape of the sharpened tip after etching of the pillar-shaped diamond monocrystal does not necessarily have the rotational symmetry necessary for obtaining a high-quality electron beam, due to surface roughness or the like. Therefore, when a focused ion beam device is used to create a rotationally symmetrical shape as needed, fabrication defects can be recovered, and the process yield is markedly enhanced, and an electron source having higher brightness can therefore be obtained.

Since the sharpened tip 29 is damaged by ion impacts from RIE, FIB fabrication, and the like, the layer of damage on the surface can be removed through exposure to hydrogen plasma or a high-temperature hydrogen atmosphere (step W). The normal electron emission ability of diamond is obtained by removing the surface damage layer of the sharpened tip, and a high-brightness electron source can be obtained as a result. When a high-temperature hydrogen atmosphere is used, the use of a hydrogen atmosphere at 300°C or higher makes it possible to efficiently remove the damage layer.

### (Embodiment 3)

Embodiment 3 of the present invention will be described with reference to FIGS. 13 through 17. First, in step A, a pillar-shaped diamond monocrystal is prepared in a size for which resist application is difficult in a microfabrication process. A rectangular solid shape is preferred for use as the shape of the pillar-shaped diamond monocrystal. Specifically, in the six sides constituting the rectangular solid, the preferred monocrystal is a monocrystal in which all six sides are (100) planes (off angle within 7°), a monocrystal in which four sides are (110) planes (off angle within 7°) and two sides are (100) planes (off angle within 7°), or a monocrystal in which two sides are (110) planes (off angle within 7°), two sides are (211) planes (off angle within 7°), and two sides are (111) planes (off angle within 7°).

A pillar-shaped diamond monocrystal having a size within a cubic space from 50 µm × 50 µm × 100 µm to 1 mm × 1 mm × 5 mm can be suitably used. When the size is less than 50 µm × 50 µm × 100 µm or larger than 1 mm × 1 mm × 5 mm, the pillar-shaped diamond monocrystal is difficult to install in an electron microscope, electron beam exposure device, or other electron beam device. In order to obtain adequate conductivity as an electron source, at least a portion preferably includes a donor or acceptor impurity in an amount of 1 × 10¹⁷ cm⁻³ or more. The donor impurity is preferably P, and the acceptor impurity is preferably B. Specifically, it is possible to use a diamond monocrystal in which a P-doped diamond thin film or a B-doped diamond thin film is epitaxially grown on a diamond monocrystal synthesized at high temperature and high pressure, or to use a vapor-phase synthetic B-doped diamond monocrystal, a high-temperature high-pressure synthetic B-containing diamond monocrystal, or the like.

At least one end of the pillar-shaped diamond monocrystal is then ground in step B, and a smooth flat surface 31 is formed on one end of the pillar-shaped diamond monocrystal 30, as shown in FIG. 13. The size of the smooth flat surface 31 is preferably a diameter of 10 µm or more in order to form a sufficiently large (high) sharpened tip as an electron source on the smooth flat surface 31 in a subsequent step. The surface roughness Ra of the smooth flat surface 11 is preferably 100 nm or less. When the surface roughness is more than 100 nm, the surface of the electron emission point of the sharpened tip formed in a subsequent step is rough, and adequate brightness as a diamond electron source is not obtained.

The smooth flat surface 31 may be formed on the entire surface of one end of the pillar-shaped diamond monocrystal 30, as shown in FIG. 13A, or the side surfaces of one end may be ground as shown in FIG. 13B, and a tapered end shape (substantially truncated-pyramid shape) having the smooth flat surface 31 on the apex part may be formed. The grinding for forming the sharp end shape (step T) may be performed immediately before or immediately after step B. Through providing the smooth flat surface 31 at the apex of such a tapered end shape, the field concentration increases at the sharpened tip ultimately obtained, and a diamond electron source having higher brightness is obtained.

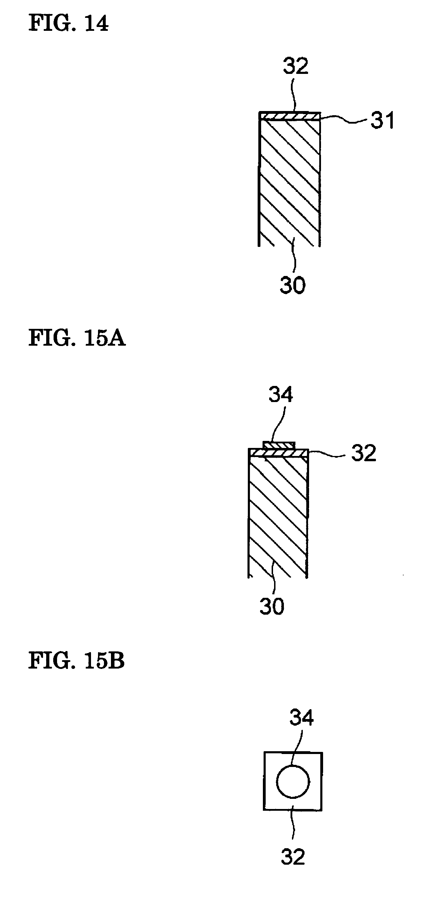

An iron-based metal or Cr layer 32 is then formed on the smooth flat surface 31 in step L, as shown in FIG. 14. The iron-based metal layer is preferably any of Fe, Ni, Co, and an alloy that includes these metals, whereby the retreating of the mask can be utilized in the same manner as Cr to efficiently sharpen the end of the diamond in a satisfactory shape when the diamond is etched using the iron-based metal mask. Since these metals have higher etching selectivity with respect to the diamond than the ceramic mask in dry etching, a higher sharpened tip is easily formed, and a diamond electron source having more excellent performance is obtained. Sputtering, CVD, or another thin-film formation device may be suitably used to form the iron-based metal or Cr layer 32.

A thin-film layer 34 having a prescribed shape is then deposited on the iron-based metal or Cr layer 32 using a focused ion beam device (FIB) in step M, as shown in FIG. 15A. The elements W (tungsten), Pt (platinum), and C (carbon), and SiOₓ, which are easily deposited using an FIB device, can be suitably used as the thin-film layer 34.

The thin-film layer 34 is deposited using an FIB device, and may therefore have any shape, but from the perspective of an electron source, the shape of the sharpened tip after sharpening of the diamond is preferably rotationally symmetrical, and the shape of the iron-based metal or Cr layer used as the mask is therefore preferably rotationally symmetrical. Specifically, the shape of the thin-film layer 34 for patterning the iron-based metal or Cr layer 32 is preferably circular, as shown in FIG. 15B. The thin-film layer 34 is also preferably disposed in the center of the surface of the iron-based metal or Cr layer 32. The diamond sharpened tip after fabrication is thereby disposed on the substantial center axis of the pillar-shaped diamond monocrystal 30, and advantages are thereby obtained in that the optical axis is easily aligned when the diamond electron source is mounted in an electron beam device.

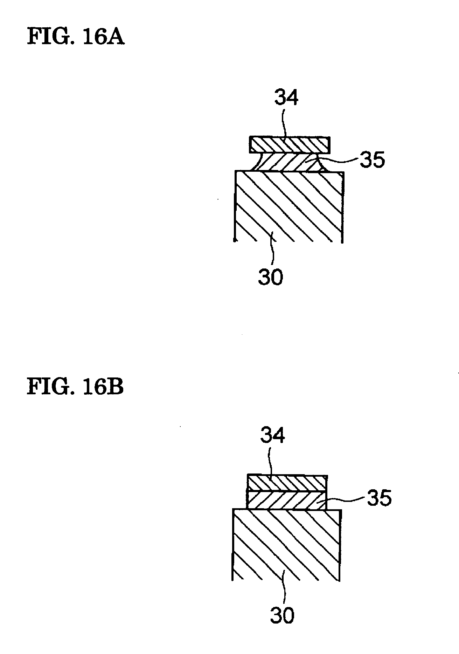

In the next step N, the iron-based metal or Cr layer 32 is etched by wet etching or dry etching using the thin-film layer 34 as a mask formed in a prescribed shape using an FIB device in step M, and a patterned iron-based metal or Cr mask 35 is fabricated, as shown in FIG. 16. When wet etching is selected at this time, since etching proceeds in isotropic fashion, the iron-based metal or Cr layer 32 becomes a peak-shaped iron-based metal or Cr mask 35 such as the one shown in FIG. 16A. When reactive ion etching (RIE) or another dry etching technique is selected, since the region directly below the thin-film layer 34 is not easily etched, the iron-based metal or Cr layer 32 becomes a cylindrical iron-based metal or Cr mask 35 such as the one shown in FIG. 16B. The thin-film layer 34 may be removed after etching is completed.

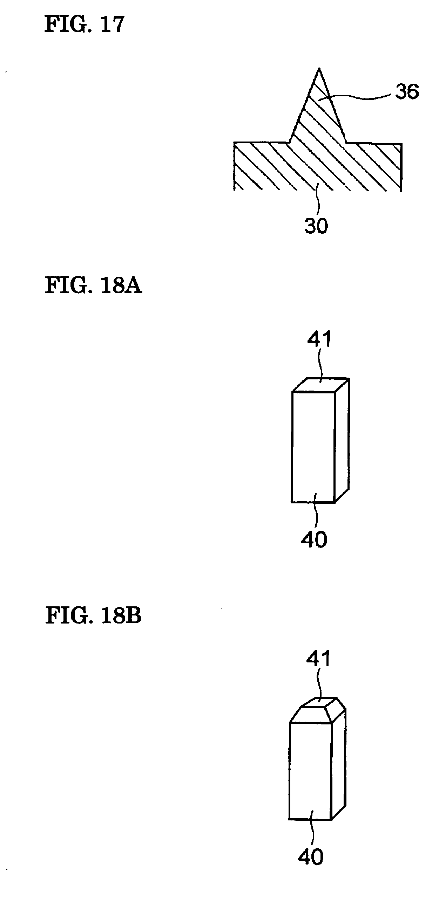

One end of the pillar-shaped diamond monocrystal 30 is then sharpened by RIE or another dry etching technique in step O using the iron-based metal or Cr mask 35. In step O, a single sharpened tip 36 may be formed at one end of the pillar-shaped diamond monocrystal 30 as shown in FIG. 17. The sharpened tip 36 preferably has a height of 10 µm or more, and a distal-end radius or distal-end curvature radius of 10 µm or less. Such a distal end shape produces a diamond electron source having practical performance as an electron source.

Furthermore, the shape of the sharpened tip 36 obtained as described above may be adjusted to a rotationally symmetrical shape using a focused ion beam device (step V). The shape of the sharpened tip 36 after etching of the pillar-shaped diamond monocrystal does not necessarily have the rotational symmetry necessary for obtaining a high-quality electron beam, due to surface roughness or the like. Therefore, when a focused ion beam device is used to create a rotationally symmetrical shape as needed, fabrication defects can be recovered, and the process yield is markedly enhanced, and an electron source having higher brightness can therefore be obtained.

Since the sharpened tip 36 is damaged by ion impacts from RIE, FIB fabrication, and the like, the layer of damage on the surface can be removed through exposure to hydrogen plasma or a high-temperature hydrogen atmosphere (step W). The normal electron emission ability of diamond is obtained by removing the surface damage layer of the sharpened tip, and a high-brightness electron source can be obtained as a result. When a high-temperature hydrogen atmosphere is used, the use of a hydrogen atmosphere at 300°C or higher makes it possible to efficiently remove the damage layer.

### (Embodiment 4)

Embodiment 4 of the present invention will be described with reference to FIGS. 18 through 20. First, in step A, a pillar-shaped diamond monocrystal, preferably a rectangular pillar-shaped diamond monocrystal, is prepared in a size for which resist application is difficult in a microfabrication process, in the same manner as in the embodiments described above. Specifically, in the six sides constituting the rectangular solid, the preferred monocrystal is a monocrystal in which all six sides are (100) planes (off angle within 7°), a monocrystal in which four sides are (110) planes (off angle within 7°) and two sides are (100) planes (off angle within 7°), or a monocrystal in which two sides are (110) planes (off angle within 7°), two sides are (211) planes (off angle within 7°), and two sides are (111) planes (off angle within 7°).

A pillar-shaped diamond monocrystal having a size within a cubic space from 50 µm × 50 µm × 100 µm to 1 mm × 1 mm × 5 mm can be suitably used. When the size is less than 50 µm × 50 µm × 100 µm or larger than 1 mm × 1 mm × 5 mm, the pillar-shaped diamond monocrystal is difficult to install in an electron microscope, electron beam exposure device, or other electron beam device. In order to obtain adequate conductivity as an electron source, at least a portion preferably includes a donor or acceptor impurity in an amount of 1 × 10¹⁷ cm⁻³ or more. The donor impurity is preferably P, and the acceptor impurity is preferably B. Specifically, it is possible to use a diamond monocrystal in which a P-doped diamond thin film or a B-doped diamond thin film is epitaxially grown on a diamond monocrystal synthesized at high temperature and high pressure, or to use a vapor-phase synthetic B-doped diamond monocrystal, a high-temperature high-pressure synthetic B-containing diamond monocrystal, or the like.

At least one end of the pillar-shaped diamond monocrystal is then ground in step B, and a smooth flat surface 41 is formed on one end of the pillar-shaped diamond monocrystal 40, as shown in FIG. 18. The size of the smooth flat surface 41 is preferably a diameter of 10 µm or more in order to form a sufficiently large (high) sharpened tip as an electron source on the smooth flat surface 41 in a subsequent step. The surface roughness Ra of the smooth flat surface 41 is preferably 100 nm or less. When the surface roughness is more than 100 nm, the surface of the electron emission point of the sharpened tip formed in a subsequent step is rough, and adequate brightness as a diamond electron source is not obtained.

The smooth flat surface 41 may be formed on the entire surface of one end of the pillar-shaped diamond monocrystal 40, as shown in FIG. 18A, or the side surfaces of one end may be ground as shown in FIG. 18B, and a tapered end shape (substantially truncated-pyramid shape) having the smooth flat surface 41 on the apex part may be formed. The grinding for forming the sharp end shape (step T) may be performed immediately before or immediately after step B. Through providing the smooth flat surface 41 at the apex of such a tapered end shape, the field concentration increases at the sharpened tip ultimately obtained, and a diamond electron source having higher brightness is obtained.

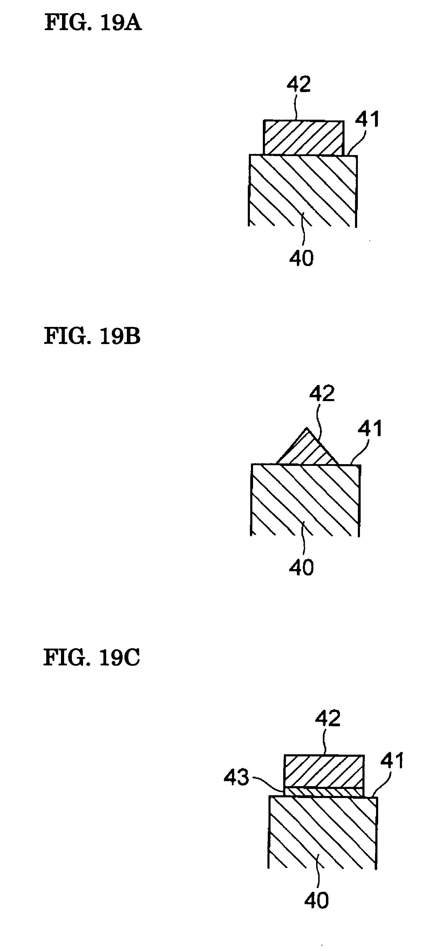

An SiOₓ layer 42 having a prescribed shape is then deposited on the smooth flat surface 41 in step P using an FIB, as shown in FIG. 19. The SiOₓ layer 42 can easily be deposited using an FIB device, and can be deposited in any shape on the smooth flat surface 41.

The SiOₓ layer 42 is used as a mask for sharpening the end of the diamond in the subsequent step Q, and therefore is preferably rotationally symmetrical from the perspective of an electron source. For example, a cylindrical SiOₓ layer 42 as shown in FIG. 19A, or a conical SiOₓ layer 42 such as the one shown in FIG. 19B may be suitably used. The SiOₓ layer 42 is also preferably disposed in the center of the surface of the smooth flat surface 41. The diamond sharpened tip after fabrication is thereby disposed on the substantial center axis of the pillar-shaped diamond monocrystal, and advantages are thereby obtained in that the optical axis is easily aligned when the diamond electron source is mounted in an electron beam device.

An adhesion strengthening layer 43 may be formed between the SiOₓ layer 42 and the pillar-shaped diamond monocrystal 40 as shown in FIG. 19B (step U). Adhesion between the smooth flat surface 41 and the SiOₓ layer 42 is enhanced by the adhesion strengthening layer 43, but a thickness range of 10 to 100 nm for the adhesion strengthening layer 43 is appropriate in order to obtain enhanced adhesion. The adhesion enhancing effects are not obtained when the thickness is less than 10 nm, and when the thickness exceeds 100 nm, the adhesion strengthening layer impedes subsequent etching of the diamond using the SiOₓ layer 42 as a mask. A Ti layer may be suitably used as the adhesion strengthening layer 43.

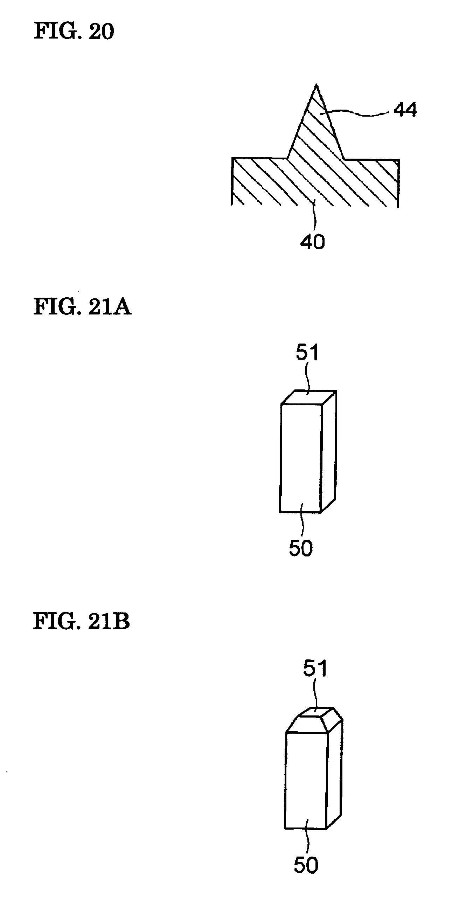

A single sharpened tip 44 is then formed at one end of the pillar-shaped diamond monocrystal 40 by RIE or another dry etching technique in step Q using the SiOₓ layer 42 as a mask, as shown in FIG. 20. The sharpened tip 44 thus formed preferably has a height of 10 µm or more, and a distal-end radius or distal-end curvature radius of 10 µm or less. Such a distal end shape produces a diamond electron source having practical performance as an electron source.

Furthermore, the shape of the sharpened tip 44 obtained as described above may be adjusted to a rotationally symmetrical shape using a focused ion beam device (step V). The shape of the sharpened tip after etching of the pillar-shaped diamond monocrystal does not necessarily have the rotational symmetry necessary for obtaining a high-quality electron beam, due to surface roughness or the like. Therefore, when a focused ion beam device is used to create a rotationally symmetrical shape as needed, fabrication defects can be recovered, and the process yield is markedly enhanced, and an electron source having higher brightness can therefore be obtained.

Since the sharpened tip 44 is damaged by ion impacts from RIE, FIB fabrication, and the like, the layer of damage on the surface can be removed through exposure to hydrogen plasma or a high-temperature hydrogen atmosphere (step W). The normal electron emission ability of diamond is obtained by removing the surface damage layer of the sharpened tip, and a high-brightness electron source can be obtained as a result. When a high-temperature hydrogen atmosphere is used, the use of a hydrogen atmosphere at 300°C or higher makes it possible to efficiently remove the damage layer.

### (Embodiment 5)

Embodiment 5 of the present invention will be described with reference to FIGS. 21 through 23. First, in step A, a pillar-shaped diamond monocrystal, preferably a rectangular pillar-shaped diamond monocrystal, is prepared in a size for which resist application is difficult in a microfabrication process, in the same manner as in the embodiments described above. Specifically, in the six sides constituting the rectangular solid, the preferred monocrystal is a monocrystal in which all six sides are (100) planes (off angle within 7°), a monocrystal in which four sides are (110) planes (off angle within 7°) and two sides are (100) planes (off angle within 7°), or a monocrystal in which two sides are (110) planes (off angle within 7°), two sides are (211) planes (off angle within 7°), and two sides are (111) planes (off angle within 7°).

A pillar-shaped diamond monocrystal having a size within a cubic space from 50 µm × 50 µm × 100 µm to 1 mm × 1 mm × 5 mm can be suitably used. When the size is less than 50 µm × 50 µm × 100 µm or larger than 1 mm × 1 mm × 5 mm, the pillar-shaped diamond monocrystal is difficult to install in an electron microscope, electron beam exposure device, or other electron beam device. In order to obtain adequate conductivity as an electron source, at least a portion preferably includes a donor or acceptor impurity in an amount of 1 × 10¹⁷ cm⁻³ or more. The donor impurity is preferably P, and the acceptor impurity is preferably B. Specifically, it is possible to appropriately use a diamond monocrystal in which a P-doped diamond thin film or a B-doped diamond thin film is epitaxially grown on a diamond monocrystal synthesized at high temperature and high pressure, or to use a vapor-phase synthetic B-doped diamond monocrystal, a high-temperature high-pressure synthetic B-containing diamond monocrystal, or the like.

At least one end of the pillar-shaped diamond monocrystal is then ground in step B, and a smooth flat surface 51 is formed on one end of the pillar-shaped diamond monocrystal 50, as shown in FIG. 21. The size of the smooth flat surface 51 is preferably a diameter of 10 µm or more in order to form a sufficiently large (high) sharpened tip as an electron source on the smooth flat surface 51 in a subsequent step. The surface roughness Ra of the smooth flat surface 51 is preferably 100 nm or less. When the surface roughness is more than 100 nm, the surface of the electron emission point of the sharpened tip formed in a subsequent step is rough, and adequate brightness as a diamond electron source is not obtained.

The smooth flat surface 51 may be formed on the entire surface of one end of the pillar-shaped diamond monocrystal 50, as shown in FIG. 21A, or the side surfaces of one end may be ground as shown in FIG. 21B, and a tapered end shape (substantially truncated-pyramid shape) having the smooth flat surface 51 on the apex part may be formed. The grinding for forming the sharp end shape (step T) may be performed immediately before or immediately after step B. Through providing the smooth flat surface 51 at the apex of such a tapered end shape, the field concentration increases at the sharpened tip ultimately obtained, and a diamond electron source having higher brightness is obtained.

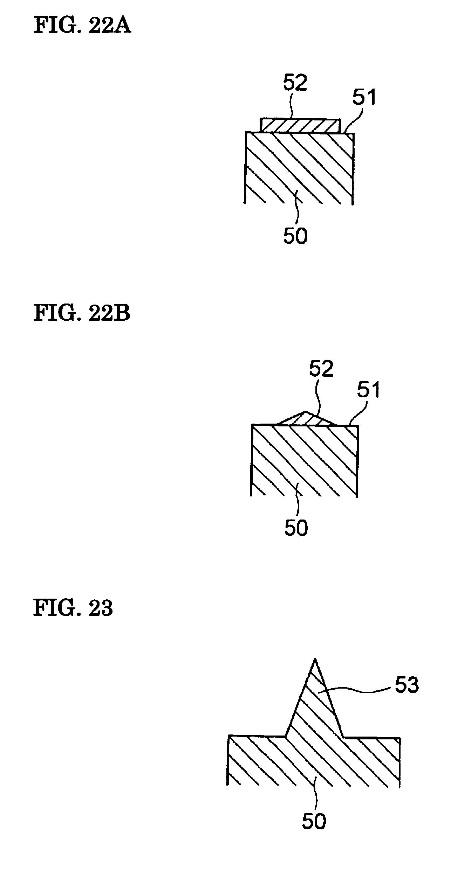

An Ni layer 52 having a prescribed shape is then deposited on the smooth flat surface 51 in step R using an FIB, as shown in FIG. 22. The Ni layer 52 can be deposited using an FIB device by using Ni(Co)₄ as a starting material. Although Ni(Co)₄ is highly poisonous and must be handled with care, the Ni(Co)₄ can be deposited in any shape on the smooth flat surface 51.

The Ni layer 52 is used as a mask for sharpening the end of the diamond in the subsequent step W, and therefore is preferably rotationally symmetrical from the perspective of an electron source. For example, a cylindrical Ni layer 52 as shown in FIG. 22A, or a conical Ni layer 52 such as the one shown in FIG. 22B may be suitably used. The Ni layer 52 is also preferably disposed in the center of the surface of the smooth flat surface 51. The diamond sharpened tip after fabrication is thereby disposed on the substantial center axis of the pillar-shaped diamond monocrystal, and advantages are thereby obtained in that the optical axis is easily aligned when the diamond electron source is mounted in an electron beam device.

Since the Ni layer 52 has higher selectivity than the ceramic mask with respect to the diamond in dry etching, a high sharpened tip can be more easily formed, and a diamond electron source having more excellent performance is obtained.

A single sharpened tip 53 is then formed at one end of the pillar-shaped diamond monocrystal 50 by RIE or another dry etching technique in step S using the Ni layer 52 as a mask, as shown in FIG. 23. The sharpened tip 53 thus formed preferably has a height of 10 µm or more, and a distal-end radius or distal-end curvature radius of 10 µm or less. Such a distal end shape produces a diamond electron source having practical performance as an electron source.

Furthermore, the shape of the sharpened tip 53 obtained as described above may be adjusted to a rotationally symmetrical shape using a focused ion beam device (step V). The shape of the sharpened tip after etching of the pillar-shaped diamond monocrystal does not necessarily have the rotational symmetry necessary for obtaining a high-quality electron beam, due to surface roughness or the like. Therefore, when a focused ion beam device is used to create a rotationally symmetrical shape as needed, fabrication defects can be recovered, and the process yield is markedly enhanced, and an electron source having higher brightness can therefore be obtained.

Lastly, since the sharpened tip 53 is damaged by ion impacts from RIE, FIB fabrication, and the like, the layer of damage on the surface can be removed through exposure to hydrogen plasma or a high-temperature hydrogen atmosphere (step W). The normal electron emission ability of diamond is obtained by removing the surface damage layer of the sharpened tip, and a high-brightness electron source can be obtained as a result. When a high-temperature hydrogen atmosphere is used, the use of a hydrogen atmosphere at 300°C or higher makes it possible to efficiently remove the damage layer.

### EXAMPLES

### (Example 1)

A diamond electron source 1a was fabricated by the steps A, B, C, D, E, and F in sequence. A B-containing (B concentration of 3 × 10¹⁹ cm⁻³) pillar-shaped diamond monocrystal synthesized at high temperature and high pressure was first prepared in step A, and was a rectangular solid having a size of 0.6 × 0.6 × 2.5 mm in which two sides were (110) planes (off angle within 7°), two sides were (211) sides (off angle within 7°), and two sides were (111) planes (off angle within 7°), and in which a P-doped epitaxial diamond thin film (P concentration of 1 × 10²⁰ cm⁻³) was grown on the (111) planes by vapor-phase epitaxy. The 0.6 × 0.6 mm sides were the (110) planes.

A 0.6 × 0.6 mm (110) plane was then ground in step B to form a smooth flat surface having a surface roughness Ra of 30 nm. In step C, an SiO₂ layer as a ceramic layer having a thickness of 4 µm was formed by CVD on the smooth flat surface. A W (tungsten) layer as a thin-film layer having a diameter of 20 µm and a thickness of 2 µm was then formed in step D by an FIB in the center of the surface of the SiO₂ ceramic layer. In step E, the SiO₂ layer was etched by RIE using the W layer as a mask, and a cylindrical ceramic mask having a diameter of 20 µm and a thickness of 4 µm was formed.

A single sharpened tip was then formed in step F at one end of the pillar-shaped diamond monocrystal by RIE using the abovementioned cylindrical ceramic mask having a diameter of 20 µm and a thickness of 4 µm. The sharpened tip thus obtained was a truncated cone shape having a height of 15 µm and a distal-end radius of 2 µm. The electron emission characteristics of the resulting diamond electron source 1a were studied using an evaluation device having an electro-optical system that was equivalent to an electron microscope. An electron beam was evaluated that was produced at an electron source temperature of 600°C, a distance of 0.4 mm between the extraction electrode aperture and the distal end of the sharpened tip, an extraction electrode aperture diameter of 0.6 mm, and an extraction voltage of 3 kV. Satisfactory results were obtained, i.e., an angular current density of 0.5 mA/sr and an energy dispersion of 0.5 eV (FWHM).

Furthermore, the distal end shape of the sharpened tip obtained in step F was adjusted by an FIB in step V, and a smooth spherical surface having a curvature radius of 1.0 µm was created. The electron emission characteristics of the diamond electron source 1b obtained in this manner were studied in the same manner as those of the diamond electron source 1a, and an angular current density of 1.0 mA/sr and an energy dispersion of 0.5 eV (FWHM) were obtained, which were better results than those produced by the abovementioned diamond electron source 1a.

The surface damage layer of the distal end part of the sharpened tip obtained in step V was then removed by hydrogen plasma treatment in step W. The electron emission characteristics of the diamond electron source 1c obtained in this manner were studied in the same manner as those of the diamond electron source 1a, and an angular current density of 1.2 mA/sr and an energy dispersion of 0.5 eV (FWHM) were obtained, which were better results than those produced by the abovementioned diamond electron source 1b.

The step T was inserted between step A and step B, and a truncated pyramid sharp end shape having a smooth flat surface at the apex thereof was formed on one end of a pillar-shaped diamond monocrystal. The smooth flat surface at the apex was a 0.1 × 0.1 mm square, and the surface roughness Ra thereof was 30 nm. A diamond electron source 1d was otherwise fabricated by the same steps as in the case of the diamond electron source 1a. The electron emission characteristics of the diamond electron source 1d were studied in the same manner as those of the diamond electron source 1a, and an angular current density of 0.7 mA/sr and an energy dispersion of 0.5 eV (FWHM) were obtained, which were better results than those produced by the abovementioned diamond electron source 1a.

The step U was inserted between step B and step C, and a Ti layer having a thickness of 10 nm was formed as an adhesion strengthening layer. A diamond electron source 1e was otherwise fabricated by the same steps as in the case of the diamond electron source 1a. The fabrication steps for the diamond electron source 1a and the diamond electron source 1e were repeated multiple times, and the process yield was surveyed, and when the process yield of the diamond electron source 1e was superior. The electron emission characteristics were also studied in the same manner as in the case of the diamond electron source 1a, and satisfactory results equivalent to those produced by the diamond electron source 1a were obtained.

The step U was inserted between step C and step D, and a Ti layer having a thickness of 10 nm was formed as an adhesion strengthening layer. A diamond electron source 1f was otherwise fabricated by the same steps as in the case of the diamond electron source 1a. The fabrication steps for the diamond electron source 1a and the diamond electron source 1f were repeated multiple times, and when the process yield was surveyed, and the process yield of the diamond electron source 1f was superior. The electron emission characteristics were also studied in the same manner as in the case of the diamond electron source 1a, and satisfactory results equivalent to those produced by the diamond electron source 1a were obtained.

Diamond electron sources 1g, 1h, 1i, and 1j were fabricated by the same steps as in the case of the diamond electron source 1a, except that a SiON layer, a SiOₓ layer, an Al₂O₃ layer, and an AlOₓ layer were used instead of the SiO₂ layer in step C. The completed shapes of the diamond electron sources were the same as that of the diamond electron source 1a. When the electron emission characteristics were studied in the same manner as in the case of the diamond electron source 1a, satisfactory results equivalent to those of the diamond electron source 1a were obtained.

A diamond electron source 1k was fabricated by the same steps as in the case of the diamond electron source 1a, except that an Ni layer having a thickness of 0.2 µm was used instead of the W layer in step D, and the SiO₂ layer was etched in step E to form a cylindrical ceramic mask having a thickness of 7 µm. The completed shape was the same as that of the diamond electron source 1a except that a truncated cone shape was obtained in which the height of the sharpened tip was 25 µm, and the distal end diameter of 2 µm. The electron emission characteristics were studied in the same manner as those of the diamond electron source 1a, and an angular current density of 0.7 mA/sr and an energy dispersion of 0.5 eV (FWHM) were obtained, which were better results than those produced by the abovementioned diamond electron source 1a.

A diamond electron source 11 was fabricated by the same steps as in the case of the diamond electron source 1a, except that a P-doped epitaxial diamond thin film was formed by vapor-phase epitaxy on a (111) plane. When the electron emission characteristics were studied in the same manner as in the case of the diamond electron source 1a except that the operating temperature was set to 1000°C, an angular current density of 0.5 mA/sr and an energy dispersion of 1.0 eV (FWHM) were obtained.

A diamond electron source 1m was fabricated by the same steps as in the case of the diamond electron source 1a, except that different etching conditions were used in step F for forming a single sharpened tip at one end of the pillar-shaped diamond monocrystal by RIE. The sharpened tip thus obtained was a truncated cone shape having a height of 15 µm and a distal end radius of 10 µm. When the electron emission characteristics of the diamond electron source 1m thus obtained were studied in the same manner as in the case of the diamond electron source 1a, an angular current density of 0.2 mA/sr and an energy dispersion of 1.0 eV (FWHM) were obtained.

### (Comparative Example 1)

A diamond electron source 1n was fabricated by the same steps as in the case of the diamond electron source 1a, except that different etching conditions were used in step F for forming a single sharpened tip at one end of the pillar-shaped diamond monocrystal by RIE. The sharpened tip thus obtained was a truncated cone shape having a height of 15 µm and a distal end radius of 12 µm. When the electron emission characteristics of the diamond electron source 1m thus obtained were studied in the same manner as in the case of the diamond electron source 1a, an angular current density of 0.1 mA/sr and an energy dispersion of 1.0 eV (FWHM) were obtained.

### (Example 2)

A diamond electron source 2a was fabricated by the steps A, B, C, G, H, I, J, and K in sequence. A B-containing (B concentration of 4 × 10¹⁹ cm⁻³) pillar-shaped diamond monocrystal synthesized at high temperature and high pressure was first prepared in step A, and was a rectangular solid having a size of 0.6 × 0.6 × 2.5 mm in which two sides were (110) planes (off angle within 7°), two sides were (211) planes (off angle within 7°), and two sides were (111) planes (off angle within 7°), and in which a P-doped epitaxial diamond thin film (P concentration of 9 × 10¹⁹ cm⁻³) was grown on the (111) planes by vapor-phase epitaxy. The 0.6 × 0.6 mm sides were the (110) planes.

A 0.6 × 0.6 mm (110) plane was then ground in step B to form a smooth flat surface having a surface roughness Ra of 30 nm. In step C, an SiO₂ layer as a ceramic layer having a thickness of 6 µm was formed by CVD on the smooth flat surface. An Ni layer as an iron-based metal layer having a thickness of 0.2 µm was then formed in step G by sputtering. In step H, a W layer having a diameter of 20 µm and a thickness of 1 µm was formed as a thin-film layer by an FIB in the center of the surface of the iron-based metal layer.

In step I, the Ni layer was etched by RIE using the W layer having a diameter of 20 µm and a thickness of 1 µm as a mask, and a patterned iron-based metal mask was formed having a diameter of 20 µm and a thickness of 0.2 µm. The SiO₂ layer was then etched by RIE in step J using the iron-based metal mask, and a cylindrical ceramic mask having a diameter of 20 µm and a thickness of 6 µm was formed.

A single sharpened tip was then formed in step K at one end of the pillar-shaped diamond monocrystal by RIE using the abovementioned cylindrical ceramic mask having a diameter of 20 µm and a thickness of 6 µm. The sharpened tip thus obtained was a truncated cone shape having a height of 23 µm and a distal-end radius of 2 µm. The electron emission characteristics of the resulting diamond electron source 2a were studied using an evaluation device having an electro-optical system that was equivalent to an electron microscope. An electron beam was evaluated that was produced at an electron source temperature of 600°C, a distance of 0.4 mm between the extraction electrode aperture and the distal end of the sharpened tip, an extraction electrode aperture diameter of 0.6 mm, and an extraction voltage of 3 kV. Satisfactory results were obtained, i.e., an angular current density of 0.6 mA/sr and an energy dispersion of 0.5 eV (FWHM).

The distal end shape of the sharpened tip obtained in step K was adjusted by an FIB in step V, and a smooth spherical surface having a curvature radius of 1.0 µm was created. The electron emission characteristics of the diamond electron source 2b obtained in this manner were studied in the same manner as those of the diamond electron source 2a, and an angular current density of 1.1 mA/sr and an energy dispersion of 0.5 eV (FWHM) were obtained, which were better results than those produced by the abovementioned diamond electron source 2a.

The surface damage layer of the distal end part of the sharpened tip obtained in step K was then removed by hydrogen plasma treatment in step W. The electron emission characteristics of the diamond electron source 2c obtained in this manner were studied in the same manner as those of the diamond electron source 2a, and an angular current density of 1.3 mA/sr and an energy dispersion of 0.5 eV (FWHM) were obtained, which were better results than those produced by the abovementioned diamond electron source 2b.

The step T was inserted between step A and step B, and a truncated pyramid sharp end shape having a smooth flat surface at the apex thereof was formed on one end of a pillar-shaped diamond monocrystal. The smooth flat surface at the apex was a 0.1 × 0.1 mm square, and the surface roughness Ra thereof was 30 nm. A diamond electron source 2d was otherwise fabricated by the same steps as in the case of the diamond electron source 2a. The electron emission characteristics of the diamond electron source 2d were studied in the same manner as those of the diamond electron source 2a, and an angular current density of 0.8 mA/sr and an energy dispersion of 0.5 eV (FWHM) were obtained, which were better results than those produced by the abovementioned diamond electron source 2a.

The step U was inserted between step B and step C, and a Ti layer having a thickness of 10 nm was formed as an adhesion strengthening layer. A diamond electron source 2e was otherwise fabricated by the same steps as in the case of the diamond electron source 2a. The fabrication steps for the diamond electron source 2a and the diamond electron source 2e were repeated multiple times, and the process yield was surveyed, and when the process yield of the diamond electron source 2e was superior. The electron emission characteristics were also studied in the same manner as in the case of the diamond electron source 1a, and satisfactory results equivalent to those produced by the diamond electron source 1a were obtained.

Furthermore, the step U was inserted between step C and step G, and a Ti layer having a thickness of 10 nm was formed as an adhesion strengthening layer. A diamond electron source 2f was otherwise fabricated by the same steps as in the case of the diamond electron source 2a. The fabrication steps for the diamond electron source 2a and the diamond electron source 2f were repeated multiple times, and the process yield was surveyed, and when the process yield of the diamond electron source 2f was superior. The electron emission characteristics were also studied in the same manner as in the case of the diamond electron source 1a, and satisfactory results equivalent to those produced by the diamond electron source 1a were obtained.

Diamond electron sources 2g, 2h, 2i, and 2j were fabricated by the same steps as in the case of the diamond electron source 2a, except that a SiON layer, a SiOₓ layer, an Al₂O₃ layer, and an AlOₓ layer were used instead of the SiO₂ layer in step C. The completed shapes of the diamond electron sources were the same as that of the diamond electron source 2a. When the electron emission characteristics were studied in the same manner as in the case of the diamond electron source 2a, satisfactory results equivalent to those of the diamond electron source 2a were obtained.

Diamond electron sources 2k, 21, 2m, and 2n were fabricated by the same steps as in the case of the diamond electron source 2a, except that an Fe layer, a Co layer, or an Ni alloy layer having a thickness of 0.1 µm or greater was formed instead of the Ni layer as the iron-based metal layer, or a Cr layer was formed instead of the iron-based metal layer in step G. The completed shapes were the same as that of the diamond electron source 2a. When the electron emission characteristics were studied in the same manner as in the case of the diamond electron source 2a, satisfactory results equivalent to those of the diamond electron source 2a were obtained.

A diamond electron source 2o was fabricated by the same steps as in the case of the diamond electron source 2a, except that a P-doped epitaxial diamond thin film was formed by vapor-phase epitaxy on a (111) plane. When the electron emission characteristics were studied in the same manner as in the case of the diamond electron source 2a except that the operating temperature was set to 1000°C, an angular current density of 0.6 mA/sr and an energy dispersion of 1.0 eV (FWHM) were obtained.

A diamond electron source 2p was fabricated by the same steps as in the case of the diamond electron source 2a, except that different etching conditions were used in step K for forming a single sharpened tip at one end of the pillar-shaped diamond monocrystal by RIE. The sharpened tip thus obtained was a truncated cone shape having a height of 23 µm and a distal end radius of 10 µm. When the electron emission characteristics of the diamond electron source 2p thus obtained were studied in the same manner as in the case of the diamond electron source 2a, an angular current density of 0.3 mA/sr and an energy dispersion of 1.0 eV (FWHM) were obtained.

### (Comparative Example 2)

A diamond electron source 2q was fabricated by the same steps as in the case of the diamond electron source 2a, except that different etching conditions were used in step K for forming a single sharpened tip at one end of the pillar-shaped diamond monocrystal by RIE. The sharpened tip thus obtained was a truncated cone shape having a height of 23 µm and a distal end radius of 15 µm. When the electron emission characteristics of the diamond electron source 2q thus obtained were studied in the same manner as in the case of the diamond electron source 2a, an angular current density of 0.1 mA/sr and an energy dispersion of 1.0 eV (FWHM) were obtained.

### (Example 3)

A diamond electron source 3a was fabricated by the steps A, B, L, M, N, and O in sequence. A B-containing (B concentration of 2 × 10¹⁹ cm⁻³) pillar-shaped diamond monocrystal synthesized at high temperature and high pressure was first prepared in step A, and was a rectangular solid having a size of 0.6 × 0.6 × 2.5 mm in which two sides were (110) planes (off angle within 7°), two sides were (211) planes (off angle within 7°), and two sides were (111) planes (off angle within 7°), and in which a P-doped epitaxial diamond thin film (P concentration of 8 × 10¹⁹ cm⁻³) was grown on the (111) planes by vapor-phase epitaxy. The 0.6 × 0.6 mm sides were the (110) planes.

A 0.6 × 0.6 mm (110) plane was then ground in step B to form a smooth flat surface having a surface roughness Ra of 30 nm. An Ni layer as an iron-based metal layer having a thickness of 1 µm was formed by sputtering on the smooth flat surface in step L. In step M, a W layer having a diameter of 20 µm and a thickness of 0.3 µm was formed as a thin-film layer by an FIB in the center of the surface of the Ni iron-based metal layer. The Ni layer was then etched by RIE in step N using the W layer as a mask, and a circular iron-based metal mask was formed having a diameter of 20 µm and a thickness of 1 µm.

A single sharpened tip was then formed in step O at one end of the pillar-shaped diamond monocrystal by RIE using the abovementioned circular iron-based metal mask having a diameter of 20 µm and a thickness of 1 µm. The sharpened tip thus obtained was a truncated cone shape having a height of 27 µm and a distal-end radius of 0.3 µm. The electron emission characteristics of the resulting diamond electron source 3a were studied using an evaluation device having an electro-optical system that was equivalent to an electron microscope. An electron beam was evaluated that was produced at an electron source temperature of 600°C, a distance of 0.4 mm between the extraction electrode aperture and the distal end of the sharpened tip, an extraction electrode aperture diameter of 0.6 mm, and an extraction voltage of 3 kV. Satisfactory results were obtained, i.e., an angular current density of 1.2 mA/sr and an energy dispersion of 0.5 eV (FWHM).

The distal end shape of the sharpened tip obtained in step O was furthermore adjusted by an FIB in step V, and a smooth spherical surface having a curvature radius of 0.1 µm was created. The electron emission characteristics of the diamond electron source 3b obtained in this manner were studied in the same manner as those of the diamond electron source 3a, and an angular current density of 1.8 mA/sr and an energy dispersion of 0.5 eV (FWHM) were obtained, which were better results than those produced by the abovementioned diamond electron source 3a.

The surface damage layer of the distal end part of the sharpened tip obtained in step V was then removed by hydrogen plasma treatment in step W. The electron emission characteristics of the diamond electron source 3c obtained in this manner were studied in the same manner as those of the diamond electron source 3a, and an angular current density of 2.1 mA/sr and an energy dispersion of 0.5 eV (FWHM) were obtained, which were better results than those produced by the abovementioned diamond electron source 3b.

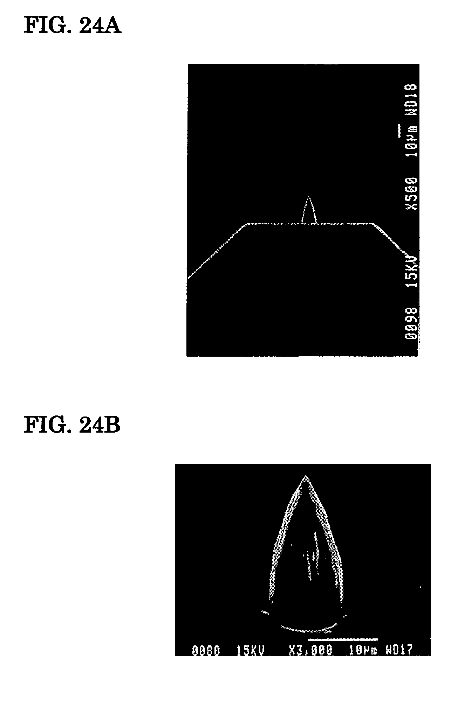

The step T was inserted between step A and step B, and a truncated pyramid sharp end shape having a smooth flat surface at the apex thereof was formed on one end of a pillar-shaped diamond monocrystal. The smooth flat surface at the apex was a 0.1 × 0.1 mm square, and the surface roughness Ra thereof was 30 nm. The diamond electron source 3d shown in FIGS. 24A and 24B was otherwise fabricated by the same steps as in the case of the diamond electron source 3a. The electron emission characteristics of the diamond electron source 3d were studied in the same manner as those of the diamond electron source 3a, and an angular current density of 1.6 mA/sr and an energy dispersion of 0.5 eV (FWHM) were obtained, which were better results than those produced by the abovementioned diamond electron source 3a.

Diamond electron sources 3e, 3f, 3g, and 3h were fabricated by the same steps as in the case of the diamond electron source 3a, except that an Fe layer, a Co layer, or an Ni alloy layer having a thickness of 0.1 to 1.5 µm was formed instead of the Ni layer as the iron-based metal layer, or a Cr layer was formed instead of the iron-based metal layer in step L. The completed shapes were the same as that of the diamond electron source 3a. When the electron emission characteristics were studied in the same manner as in the case of the diamond electron source 3a, satisfactory results equivalent to those of the diamond electron source 3a were obtained.

A diamond electron source 3i was fabricated by the same steps as in the case of the diamond electron source 3a, except that different etching conditions were used in step O for forming a single sharpened tip at one end of the pillar-shaped diamond monocrystal by RIE. The sharpened tip thus obtained was a truncated cone shape having a height of 27 µm and a distal end radius of 10 µm. When the electron emission characteristics of the diamond electron source 3i thus obtained were studied in the same manner as in the case of the diamond electron source 3a, an angular current density of 0.4 mA/sr and an energy dispersion of 1.0 eV (FWHM) were obtained.

### (Comparative Example 3)

A diamond electron source 3j was fabricated by the same steps as in the case of the diamond electron source 3a, except that different etching conditions were used in step O for forming a single sharpened tip at one end of the pillar-shaped diamond monocrystal by RIE. The sharpened tip thus obtained was a truncated cone shape having a height of 27 µm and a distal end radius of 15 µm. When the electron emission characteristics of the diamond electron source 3j thus obtained were studied in the same manner as in the case of the diamond electron source 3a, an angular current density of 0.1 mA/sr and an energy dispersion of 1.0 eV (FWHM) were obtained.

### (Example 4)

A diamond electron source 4a was fabricated by the steps A, B, P and Q in sequence. A B-containing (B concentration of 3 × 10¹⁹ cm⁻³) pillar-shaped diamond monocrystal synthesized at high temperature and high pressure was first prepared in step A, and was a rectangular solid having a size of 0.6 × 0.6 × 2.5 mm in which two sides were (110) planes (off angle within 7°), two sides were (211) planes (off angle within 7°), and two sides were (111) planes (off angle within 7°), and in which a P-doped epitaxial diamond thin film (P concentration of 1 × 10²⁰ cm⁻³) was grown on the (111) planes by vapor-phase epitaxy. The 0.6 × 0.6 mm sides were the (110) planes.

A 0.6 × 0.6 mm (110) plane was then ground in step B to form a smooth flat surface having a surface roughness Ra of 30 nm. In step P, a cylindrical SiOₓ layer having a diameter of 20 µm and a thickness of 5 µm was formed by an FIB.

A single sharpened tip was then formed in step Q at one end of the pillar-shaped diamond monocrystal by RIE using the abovementioned cylindrical SiOₓ layer having a diameter of 20 µm and a thickness of 5 µm. The sharpened tip thus obtained was a truncated cone shape having a height of 18 µm and a distal-end radius of 2 µm. The electron emission characteristics of the resulting diamond electron source 4a were studied using an evaluation device having an electro-optical system that was equivalent to an electron microscope. An electron beam was evaluated that was produced at an electron source temperature of 600°C, a distance of 0.4 mm between the extraction electrode aperture and the distal end of the sharpened tip, an extraction electrode aperture diameter of 0.6 mm, and an extraction voltage of 3 kV. Satisfactory results were obtained, i.e., an angular current density of 0.6 mA/sr and an energy dispersion of 0.5 eV (FWHM).

The distal end shape of the sharpened tip obtained in step Q was furthermore adjusted by an FIB in step V, and a smooth spherical surface having a curvature radius of 1.0 µm was created. The electron emission characteristics of the diamond electron source 4b obtained in this manner were studied in the same manner as those of the diamond electron source 4a, and an angular current density of 1.8 mA/sr and an energy dispersion of 0.5 eV (FWHM) were obtained, which were better results than those produced by the abovementioned diamond electron source 4a.

The surface damage layer of the distal end part of the sharpened tip obtained in step Q was then removed by hydrogen plasma treatment in step W. The electron emission characteristics of the diamond electron source 4c obtained in this manner were studied in the same manner as those of the diamond electron source 4a, and an angular current density of 1.3 mA/sr and an energy dispersion of 0.5 eV (FWHM) were obtained, which were better results than those produced by the abovementioned diamond electron source 4a.

The step T was inserted between step A and step B, and a truncated pyramid sharp end shape having a smooth flat surface at the apex thereof was formed on one end of a pillar-shaped diamond monocrystal. The smooth flat surface at the apex was a 0.1 × 0.1 mm square, and the surface roughness Ra thereof was 30 nm. A diamond electron source 4d was otherwise fabricated by the same steps as in the case of the diamond electron source 4a. The electron emission characteristics of the diamond electron source 4d were studied in the same manner as those of the diamond electron source 4a, and an angular current density of 0.8 mA/sr and an energy dispersion of 0.5 eV (FWHM) were obtained, which were better results than those produced by the abovementioned diamond electron source 4a.

The step U was inserted between step B and step P, and a Ti layer having a thickness of 10 nm was formed as an adhesion strengthening layer. A diamond electron source 4e was otherwise fabricated by the same steps as in the case of the diamond electron source 4a. The fabrication steps for the diamond electron source 4a and the diamond electron source 4e were repeated multiple times, and the process yield was surveyed, and when the process yield of the diamond electron source 4e was superior. The electron emission characteristics were also studied in the same manner as in the case of the diamond electron source 1a, and satisfactory results equivalent to those produced by the diamond electron source 1a were obtained.

A diamond electron source 4f was fabricated by the same steps as in the case of the diamond electron source 4a, except that different etching conditions were used in step Q for forming a single sharpened tip at one end of the pillar-shaped diamond monocrystal by RIE. The sharpened tip thus obtained was a truncated cone shape having a height of 18 µm and a distal end radius of 10 µm. When the electron emission characteristics of the diamond electron source 4f thus obtained were studied in the same manner as in the case of the diamond electron source 4a, an angular current density of 0.3 mA/sr and an energy dispersion of 1.0 eV (FWHM) were obtained.

### (Comparative Example 4)

A diamond electron source 4g was fabricated by the same steps as in the case of the diamond electron source 4a, except that different etching conditions were used in step Q for forming a single sharpened tip at one end of the pillar-shaped diamond monocrystal by RIE. The sharpened tip thus obtained was a truncated cone shape having a height of 18 µm and a distal end radius of 11 µm. When the electron emission characteristics of the diamond electron source 4g thus obtained were studied in the same manner as in the case of the diamond electron source 4a, an angular current density of 0.1 mA/sr and an energy dispersion of 1.0 eV (FWHM) were obtained.

### (Example 5)

A diamond electron source 5a was fabricated by the steps A, B, R and S in sequence. A B-containing (B concentration of 2 × 10¹⁹ cm⁻³) pillar-shaped diamond monocrystal synthesized at high temperature and high pressure was first prepared in step A, and was a rectangular solid having a size of 0.6 × 0.6 × 2.5 mm in which two sides were (110) planes (off angle within 7°), two sides were (211) planes (off angle within 7°), and two sides were (111) planes (off angle within 7°), and in which a P-doped epitaxial diamond thin film (P concentration of 9 × 10¹⁹ cm⁻³) was grown on the (111) planes by vapor-phase epitaxy. The 0.6 × 0.6 mm sides were the (110) planes.

A 0.6 × 0.6 mm (110) plane was then ground in step B to form a smooth flat surface having a surface roughness Ra of 30 nm. In step R, a cylindrical Ni layer having a diameter of 20 µm and a thickness of 0.8 µm was formed by an FIB.

A single sharpened tip was then formed in step S at one end of the pillar-shaped diamond monocrystal by RIE using the abovementioned cylindrical Ni layer having a diameter of 20 µm and a thickness of 0.8 µm. The sharpened tip thus obtained was a truncated cone shape having a height of 21 µm and a distal-end radius of 0.3 µm. The electron emission characteristics of the resulting diamond electron source 5a were studied using an evaluation device having an electro-optical system that was equivalent to an electron microscope. An electron beam was evaluated that was produced at an electron source temperature of 600°C, a distance of 0.4 mm between the extraction electrode aperture and the distal end of the sharpened tip, an extraction electrode aperture diameter of 0.6 mm, and an extraction voltage of 3 kV. Satisfactory results were obtained, i.e., an angular current density of 1.0 mA/sr and an energy dispersion of 0.5 eV (FWHM).

The distal end shape of the sharpened tip obtained in step S was furthermore adjusted by an FIB in step V, and a smooth spherical surface having a curvature radius of 0.2 µm was created. The electron emission characteristics of the diamond electron source 5b obtained in this manner were studied in the same manner as those of the diamond electron source 5a, and an angular current density of 1.4 mA/sr and an energy dispersion of 0.5 eV (FWHM) were obtained, which were better results than those produced by the abovementioned diamond electron source 5a.

The surface damage layer of the distal end part of the sharpened tip obtained in step S was then removed by hydrogen plasma treatment in step W. The electron emission characteristics of the diamond electron source 5c obtained in this manner were studied in the same manner as those of the diamond electron source 5a, and an angular current density of 1.7 mA/sr and an energy dispersion of 0.5 eV (FWHM) were obtained, which were better results than those produced by the abovementioned diamond electron source 5a.

The step T was inserted between step A and step B, and a truncated pyramid sharp end shape having a smooth flat surface at the apex thereof was formed on one end of a pillar-shaped diamond monocrystal. The smooth flat surface at the apex was a 0.1 × 0.1 mm square, and the surface roughness Ra thereof was 30 nm. A diamond electron source 5d was otherwise fabricated by the same steps as in the case of the diamond electron source 5a. The electron emission characteristics of the diamond electron source 5d were studied in the same manner as those of the diamond electron source 5a, and an angular current density of 1.3 mA/sr and an energy dispersion of 0.5 eV (FWHM) were obtained, which were better results than those produced by the abovementioned diamond electron source 5a.

A diamond electron source 5e was fabricated by the same steps as in the case of the diamond electron source 5a, except that different etching conditions were used in step S for forming a single sharpened tip at one end of the pillar-shaped diamond monocrystal by RIE. The sharpened tip thus obtained was a truncated cone shape having a height of 21 µm and a distal end radius of 9 µm. When the electron emission characteristics of the diamond electron source 5e thus obtained were studied in the same manner as in the case of the diamond electron source 5a, an angular current density of 0.3 mA/sr and an energy dispersion of 1.0 eV (FWHM) were obtained.

### (Comparative Example 5)

A diamond electron source 5f was fabricated by the same steps as in the case of the diamond electron source 5a, except that different etching conditions were used in step S for forming a single sharpened tip at one end of the pillar-shaped diamond monocrystal by RIE. The sharpened tip thus obtained was a truncated cone shape having a height of 21 µm and a distal end radius of 11 µm. When the electron emission characteristics of the diamond electron source 5f thus obtained were studied in the same manner as in the case of the diamond electron source 5a, an angular current density of 0.1 mA/sr and an energy dispersion of 1.0 eV (FWHM) were obtained.

## Claims

1. A method for manufacturing a diamond electron source having a single sharpened tip as an electron emission point of a diamond, said method comprising:
a step A of preparing a pillar-shaped diamond monocrystal of a size for which resist application is difficult in a microfabrication process;
a step B of polishing at least one end of the pillar-shaped diamond monocrystal and forming a smooth flat surface;
a step C of forming a ceramic layer on the smooth flat surface;
a step D of depositing and forming a thin-film layer having a prescribed shape on at least a portion of the ceramic layer using a focused ion beam device;
a step E of patterning the ceramic layer by wet etching or dry etching using the thin-film layer as a mask, and fabricating a ceramic mask; and
a step F of using the ceramic mask to form a single sharpened tip at the one end of the pillar-shaped diamond monocrystal by dry etching.

2. A method for manufacturing a diamond electron source having a single sharpened tip as an electron emission point of a diamond, said method comprising:
a step A of preparing a pillar-shaped diamond monocrystal of a size for which resist application is difficult in a microfabrication process;
a step B of polishing at least one end of the pillar-shaped diamond monocrystal and forming a smooth flat surface;
a step C of forming a ceramic layer on the smooth flat surface;
a step G of forming an iron-based metal or Cr (chrome) layer on the ceramic layer;
a step H of depositing and forming a thin-film layer having a prescribed shape on at least a portion of the iron-based metal or Cr layer using a focused ion beam device;
a step I of patterning the iron-based metal or Cr layer by wet etching or dry etching using the thin-film layer as a mask, and fabricating an iron-based metal or Cr mask;
a step J of using the iron-based metal or Cr mask to pattern the ceramic layer by wet etching or dry etching, and fabricating a ceramic mask; and
a step K of using the patterned ceramic mask to form a single sharpened tip at the one end of the pillar-shaped diamond monocrystal by dry etching.

3. A method for manufacturing a diamond electron source having a single sharpened tip as an electron emission point of a diamond, said method comprising:
a step A of preparing a pillar-shaped diamond monocrystal of a size for which resist application is difficult in a microfabrication process;
a step B of polishing at least one end of the pillar-shaped diamond monocrystal and forming a smooth flat surface;
a step L of forming an iron-based metal or Cr layer on the smooth flat surface;
a step M of depositing and forming a thin-film layer having a prescribed shape on at least a portion of the iron-based metal or Cr layer using a focused ion beam device;
a step N of patterning the iron-based metal or Cr layer by wet etching or dry etching using the thin-film layer as a mask, and fabricating an iron-based metal or Cr mask; and
a step O of using the iron-based metal or Cr mask to form a single sharpened tip at the one end of the pillar-shaped diamond monocrystal by dry etching.

4. A method for manufacturing a diamond electron source having a single sharpened tip as an electron emission point of a diamond, said method comprising:
a step A of preparing a pillar-shaped diamond monocrystal of a size for which resist application is difficult in a microfabrication process;
a step B of polishing at least one end of the pillar-shaped diamond monocrystal and forming a smooth flat surface;
a step P of depositing and forming an SiOₓ layer having a prescribed shape on at least a portion of the smooth flat surface using a focused ion beam device; and
a step Q of forming a single sharpened tip at the one end of the pillar-shaped diamond monocrystal by dry etching using the SiOₓ layer as a mask.

5. A method for manufacturing a diamond electron source having a single sharpened tip as an electron emission point of a diamond, said method comprising:
a step A of preparing a pillar-shaped diamond monocrystal of a size for which resist application is difficult in a microfabrication process;
a step B of polishing at least one end of the pillar-shaped diamond monocrystal and forming a smooth flat surface;
a step R of depositing and forming a Ni (nickel) layer having a prescribed shape on at least a portion of the smooth flat surface using a focused ion beam device; and
a step S of forming a single sharpened tip at the one end of the pillar-shaped diamond monocrystal by dry etching using the Ni layer as a mask.

6. The method for manufacturing a diamond electron source according to any of claims 1 through 5, further comprising
a step T of grinding and sharpening a side surface of the one end of the pillar-shaped diamond monocrystal so that a smooth flat surface is formed at an apex part immediately before or immediately after the step B of polishing the one end of the pillar-shaped diamond monocrystal and forming a smooth flat surface.

7. The method for manufacturing a diamond electron source according to claim 1 or 2, further comprising
a step U of forming an adhesion strengthening layer between the smooth flat surface and the ceramic layer.

8. The method for manufacturing a diamond electron source according to claim 4, further comprising
a step U of forming an adhesion strengthening layer between the smooth flat surface and the SiOₓ layer.

9. The method for manufacturing a diamond electron source according to claim 1, further comprising
a step U of forming an adhesion strengthening layer between the ceramic layer and the thin-film layer.

10. The method for manufacturing a diamond electron source according to claim 2, further comprising
a step U of forming an adhesion strengthening layer between the ceramic layer and the iron-based metal or Cr layer.

11. The method for manufacturing a diamond electron source according to any of claims 1 through 5, further comprising
a step V of using a focused ion beam device to adjust a shape of the sharpened tip to a rotationally symmetrical shape.

12. The method for manufacturing a diamond electron source according to any of claims 1 through 5, further comprising
a step W of removing damage due to surface processing by exposing the sharpened tip to hydrogen plasma or a high-temperature hydrogen atmosphere.

13. The method for manufacturing a diamond electron source according to claim 1 or 2, wherein
the ceramic layer is any of SiO₂, SiON, SiOₓ, Al₂O₃, and AlOₓ.

14. The method for manufacturing a diamond electron source according to any of claims 1 through 3, wherein
the thin-film layer is W (tungsten).

15. The method for manufacturing a diamond electron source according to claim 1, wherein
the thin-film layer is Ni.

16. The method for manufacturing a diamond electron source according to claim 2 or 3, wherein
the iron-based metal layer is any of Fe (iron), Ni, Co (cobalt), and an alloy that includes Fe, Ni, or Co.

17. The method for manufacturing a diamond electron source according to any of claims 1 through 5, wherein
a size of the pillar-shaped diamond monocrystal is within a cubic space from 50 µm × 50 µm × 100 µm to 1 mm × 1 mm × 5 mm.

18. The method for manufacturing a diamond electron source according to any of claims 1 through 5, wherein
at least a portion of the pillar-shaped diamond monocrystal includes 1 × 10¹⁷ cm⁻³ or more of a donor impurity or an acceptor impurity.

19. The method for manufacturing a diamond electron source according to any of claims 1 through 5, wherein
a size of the smooth flat surface is a diameter of 10 µm or more.

20. The method for manufacturing a diamond electron source according to any of claims 1, 2, and 4, wherein
a thickness of the ceramic layer or the SiOₓ layer is 1 µm or greater.

21. The method for manufacturing a diamond electron source according to any of claims 7 through 10, wherein
a thickness of the adhesion strengthening layer is in a range from 10 to 100 nm.

22. The method for manufacturing a diamond electron source according to any of claims 1 through 5, wherein
the sharpened tip has a height of 10 µm or more and a distal-end radius or distal-end curvature radius of 10 µm or less.

23. A diamond electron source comprising a pillar-shaped diamond monocrystal having a size within a cubic space from 50 µm × 50 µm × 100 µm to 1 mm × 1 mm × 5 mm, wherein one end of the pillar-shaped diamond monocrystal is a smooth flat surface having a sharpened tip that has a height of 10 µm or more and a distal-end radius or distal-end curvature radius of 10 µm or less on the flat surface.

24. The diamond electron source according to claim 23, wherein
the one end of the pillar-shaped diamond monocrystal is a pointed shape having a smooth flat surface at an apex, a size of the flat surface is a diameter of 10 µm or more, and the flat surface has a sharpened tip that has a height of 10 µm or more and a distal-end radius or distal-end curvature radius of 10 µm or less.

25. The diamond electron source according to claim 23 or 24, wherein
at least a portion thereof includes 1 × 10¹⁷ cm⁻³ or more of a donor impurity or an acceptor impurity.

26. The diamond electron source according to any of claims 23 through 25, wherein
an electron beam is obtained having an angular current density of 0.2 mA/sr or higher.

27. The diamond electron source according to any of claims 23 through 25, wherein
an electron beam is obtained having an angular current density of 0.2 mA/sr or higher and an energy dispersion having a FWHM (Full Width at Half Maximum) of 1.0 eV or less.
